# FASCICULE DE BREVET EUROPEEN

(11) **EP 3 298 421 B1**
(45) Date de publication et mention de la délivrance du brevet: **24.11.2021**
(21) Numéro de dépôt: 16713470.9
(22) Date de dépôt: 01.04.2016
(51) Int. Cl.: G01R 33/58

(54) **MODULE ET PROCÉDÉ DE PRODUCTION, DISPOSITIF ET PROCÉDÉ D'IMAGERIE ET PROGRAMMES EN IRM ET/OU SRM**
HERSTELLUNGSMODUL UND -VERFAHREN, BILDGEBUNGSVORRICHTUNG UND -VERFAHREN SOWIE MRT- UND/ODER MRS-PROGRAMME
PRODUCTION MODULE AND METHOD, IMAGING DEVICE AND METHOD AND MRI AND/OR MRS PROGRAMS

(30) Priorité: 20.05.2015 FR 1554502
(43) Date de publication de la demande: 28.03.2018
(73) Titulaire: Université de Rennes I, 35000 Rennes Cedex (FR); Institut National de la Santé et de la Recherche Médicale (INSERM), 75013 Paris (FR); Fondat Region Ouest Ligue Cancer, 35000 Rennes (FR)
(72) Inventeur: SAINT-JALMES, Hervé, 35200 Rennes (FR); GAMBAROTA, Giulio, 35000 Rennes (FR)
(74) Mandataire: Regimbeau
(86) Numéro de dépôt international: PCT/EP2016/057286
(87) Numéro de publication internationale: WO 2016/184595

(56) Documents cités:
- SAINT-JALMES HERVÉ ET AL: "ViP MRI: virtual phantom magnetic resonance imaging", MAGNETIC RESONANCE MATERIALS IN PHYSICS, BIOLOGY AND MEDICINE, SPRINGER, DE, GB, vol. 27, no. 5, 15 décembre 2013 (2013-12-15), pages 419-424, XP035397696, ISSN: 0968-5243, DOI: 10.1007/S10334-013-0425-0 [extrait le 2013-12-15] cité dans la demande
- SHARP JONATHAN ET AL: "The integration of real and virtual magnetic resonance imaging experiments in a single instrument", REVIEW OF SCIENTIFIC INSTRUMENTS, AIP, MELVILLE, NY, US, vol. 80, no. 9, 23 septembre 2009 (2009-09-23), pages 93709-93709, XP012128497, ISSN: 0034-6748, DOI: 10.1063/1.3202410
- SALVATI R. ET AL: "Virtual Phantom (ViP) MRI: a method to generate virtual phantoms that mimic water-fat systems", PROCEEDINGS OF THE INTERNATIONAL SOCIETY FOR MAGNETIC RESONANCE IN MEDICINE, 23ND ANNUAL MEETING AND EXHIBITION, TORONTO, CANADA, 30 MAY - 5 JUNE 2015, vol. 23, 15 mai 2015 (2015-05-15), page 3086, XP040668763,
- S. HEINZER-SCHWEIZER ET AL: "In-vivo assessment of tissue metabolite levels using 1H MRS and the Electric REference To access In vivo Concentrations (ERETIC) method", NMR IN BIOMEDICINE., vol. 23, no. 4, 25 janvier 2010 (2010-01-25), pages 406-413, XP055253349, GB ISSN: 0952-3480, DOI: 10.1002/nbm.1476
- NICHOLAS P ET AL: "The Virtual NMR Spectrometer: A Computer Program for Efficient Simulation of NMR Experiments Involving Pulsed Field Gradients", JOURNAL OF MAGNETIC RESONANCE, ACADEMIC PRESS, ORLANDO, FL, US, vol. 145, no. 2, 1 août 2000 (2000-08-01), pages 262-275, XP004406870, ISSN: 1090-7807, DOI: 10.1006/JMRE.2000.2108
- AKOKA S ET AL: "Improvement of the ERETIC method by digital synthesis of the signal and addition of a broadband antenna inside the NMR probe", INSTRUMENTATION SCIENCE & TECHNOLOGY, TAYLOR & FRANCIS INC, US, vol. 30, no. 1, 1 novembre 2002 (2002-11-01), pages 21-29, XP009145916, ISSN: 1073-9149, DOI: 10.1081/CI-100108768
- LARS G. HANSON ET AL: "Encoding of electrophysiology and other signals in MR images", JOURNAL OF MAGNETIC RESONANCE IMAGING, vol. 25, no. 5, 24 avril 2007 (2007-04-24) , pages 1059-1066, XP055253248, US ISSN: 1053-1807, DOI: 10.1002/jmri.20906 cité dans la demande

## Description

L'invention concerne le domaine de l'IRM et/ou SRM, les appareils et procédés d'IRM et/ou de SRM, notamment les scanners IRM et/ou SRM.

IRM est l'abréviation de "Imagerie par Résonance Magnétique".

SRM est l'abréviation de "Spectroscopie par Résonance Magnétique". Les dispositifs d'IRM et/ou de SRM sont utilisés notamment pour créer ou reconstruire des images et/ou des spectres d'une région d'un objet ou d'un corps à étudier, pouvant être par exemple un organe d'un être vivant, pouvant être un être humain, comme par exemple son cerveau.

On connaît ainsi par le document FR 2 735 865 un dispositif d'analyse par résonance magnétique nucléaire RMN, qui comprend des moyens électroniques aptes à générer un signal radiofréquence contrôlé ayant les caractéristiques d'un signal RMN et des moyens récepteurs et de traitement adaptés pour détecter ce signal radiofréquence lors de l'acquisition du signal RMN de l'échantillon et utiliser le signal radiofréquence ainsi détecté. Le document indique que le signal radiofréquence peut trouver application dans le domaine de l'imagerie par résonance magnétique nucléaire, notamment par génération d'une bande de fréquence continue permettant de créer dans l'image une zone de référence d'intensité calibrée pour la mesure du bruit présent dans l'image pour permettre l'exploitation quantitative des images.

Le document "ViP MRI: Virtual Phantom Magnetic Resonance Imaging" de Saint-Jalmes Hervé et al., de la revue Magnetic Resonance Materials in Physics, Biology and Medicine vol. 27, n°5, du 15 décembre 2013, pages 419-424, décrit un module selon le préambule de la revendication 1.

Le document « Encoding of Electrophysiology and Other Signals in MR Images » concerne un dispositif d'imagerie IRM, dans lequel des signaux électrophysiologiques d'oeil ou de cœur sont amplifiés et échantillonnés, pour être encodés sur des porteuses radiofréquence (RF) émises par une antenne. Les signaux sont alors détectés par le scanner d'IRM. Les signaux peuvent être reconstruits à partir d'un spectrogramme des données enregistrées par le scanner IRM, et fournissent ainsi un signal de calibration, d'intensité constante.

Les dispositifs de l'art antérieur ainsi présentés présentent donc une limitation non négligeable : il n'est pas possible de visualiser dans l'image IRM ou sur le spectre SRM une référence virtuelle dynamique.

Le but de la présente invention est de proposer un dispositif permettant d'insérer un objet virtuel de référence, dont l'une des caractéristiques (la forme et/ou l'intensité en IRM, la position, la largeur et/ou la position du pic ou des pics en SRM) puisse varier en fonction du temps, ces variations étant contrôlées de façon à être synchronisées avec un signal extérieur (décorrélé du scanner IRM).

La présente invention pourrait alors permettre, en plus de fournir des moyens de calibration des systèmes IRM et/ou SRM, d'avoir une lecture des acquisitions IRM et/ou SRM de façon synchronisée avec un évènement extérieur, pour pouvoir en tirer les conclusions adéquates. Ce problème n'étant pas résolu par l'état de la technique.

L'invention vise à obtenir un module de production d'un signal de référence IRM et/ou SRM amélioré par rapport à l'état de la technique pour résoudre ce problème.

A cet effet, un premier objet de l'invention est un module de production d'un signal de référence IRM et/ou SRM suivant la revendication 1.

Suivant un mode de réalisation, le moyen de fourniture d'un signal prescrit représentant un objet virtuel d'IRM et/ou de SRM comporte une mémoire dans laquelle est enregistré comme signal prescrit représentant un objet virtuel d'IRM et/ou de SRM une transformée de Fourier, dans l'espace des k, de l'objet virtuel ou une représentation dans l'espace des k réciproque de l'objet virtuel.

Suivant un mode de réalisation, dans la mémoire est enregistrée une multiplicité de transformées de Fourier de respectivement une multiplicité d'objets virtuels distincts dans l'espace des k ou une multiplicité de représentations dans l'espace des k réciproque d'une multiplicité d'objets virtuels (RVV) distincts, les transformées de Fourier ou les représentations dans l'espace des k réciproque d'une multiplicité d'objets virtuels distincts ayant des amplitudes distinctes les unes des autres et/ou des formes distinctes les unes des autres et/ou des positions distinctes les unes des autres.

Suivant un mode de réalisation, l'objet virtuel d'IRM est une représentation visuelle du signal de référence d'IRM dans une image d'IRM.

Suivant un mode de réalisation, le moyen de génération comporte un élément de multiplication du signal prescrit d'objet virtuel ou d'un signal obtenu à partir au moins du signal prescrit d'objet virtuel par le signal temporel de stimulation extérieur.

Suivant un mode de réalisation, le moyen de génération comporte un élément de transposition fréquentielle du signal prescrit d'objet virtuel ou d'un signal obtenu à partir au moins du signal prescrit d'objet virtuel à une ou plusieurs fréquences déterminées d'IRM et/ou de SRM.

Suivant un mode de réalisation, la fréquence déterminée est la fréquence de Larmor d'IRM et/ou de SRM.

Suivant un mode de réalisation, le moyen de génération comporte un élément de déclenchement du signal prescrit d'objet virtuel ou d'un signal obtenu à partir au moins du signal prescrit d'objet virtuel une pluralité de fois successives selon un séquencement déterminé en fonction du signal de synchronisation IRM et/ou SRM.

Suivant un mode de réalisation, le séquencement déterminé est un séquencement du type EPI (EPI signifiant Echo Planar Imaging) pour le signal de synchronisation IRM, l'objet virtuel d'IRM et le signal de référence IRM.

Suivant un mode de réalisation, le séquencement déterminé est un retard du signal prescrit d'objet virtuel basé sur un temps d'écho extrait du signal de synchronisation IRM, pour l'objet virtuel d'IRM et pour le signal de référence IRM.

Suivant un mode de réalisation, la sortie est reliée à une antenne d'émission du signal de référence IRM et/ou SRM.

Suivant un mode de réalisation, le signal de stimulation est un signal de commande de stimulation d'un être vivant.

Suivant un mode de réalisation, le signal de stimulation comprend au moins un signal de commande de stimulation sensorielle et/ou au moins un signal de commande d'injection d'un produit de contraste.

Un deuxième objet de l'invention est un procédé de production d'un signal de référence IRM et/ou SRM, à l'aide du module de production tel que décrit ci-dessus, selon la revendication 15, caractérisé en ce que
- l'on envoie par un module de commande de stimulation à une deuxième entrée de réception, faisant partie du module de production, un signal temporel de stimulation extérieur,
- l'on envoie, par un ensemble de mesure d'IRM et/ou de SRM, à une première entrée de réception, faisant partie du module de production, un signal de synchronisation IRM et/ou SRM,
- un moyen de fourniture, faisant partie du module de production, fournit un signal prescrit représentant un objet virtuel d'IRM et/ou de SRM,
- un moyen de génération, faisant partie du module de production, utilise le signal de synchronisation IRM et/ou SRM, le signal temporel de stimulation extérieur et le signal prescrit d'objet virtuel d'IRM et/ou de SRM, pour générer le signal de référence IRM et/ou SRM, de telle sorte que le signal de référence IRM et/ou SRM varie temporellement de la même manière qu'une caractéristique temporelle déterminée du signal temporel de stimulation extérieur et en synchronisation avec le signal de synchronisation IRM et/ou SRM,
- une sortie de fourniture, faisant partie du module de production, fournit le signal de référence IRM et/ou SRM.

Un troisième objet de l'invention est un programme d'ordinateur, comportant des instructions pour la mise en œuvre du procédé de production d'un signal de référence IRM et/ou SRM tel que décrit ci-dessus, lorsqu'il est mis en œuvre sur un calculateur.

Un quatrième objet de l'invention est un dispositif d'imagerie IRM et/ou SRM, tel que défini par la revendication 17, comportant :
- un ensemble de mesure d'IRM et/ou de SRM, servant à l'émission de signaux d'excitation IRM et/ou SRM dans un volume d'examen dans lequel se trouve un corps à étudier et à la détection de signaux de réponse IRM et/ou SRM émis par le corps en réponse à ces signaux d'excitation,
caractérisé en ce que le dispositif comporte en outre :
- le module de production d'un signal de référence IRM et/ou SRM tel que décrit ci-dessus, dont la première entrée de réception est connectée à une sortie de fourniture du signal de synchronisation IRM et/ou SRM de l'ensemble de mesure, et dont la deuxième entrée de réception est connectée à un module de commande de stimulation fournissant le signal temporel de stimulation extérieur,
- au moins une antenne d'émission, qui est distincte de l'ensemble de mesure et qui est connectée au module de production pour émettre le signal de référence IRM et/ou SRM, de telle sorte que le signal de référence IRM et/ou SRM ayant été émis par l'antenne d'émission soit détectable par l'ensemble de mesure,
- un module de commande, connecté à l'ensemble de mesure et configuré pour générer, par traitement IRM et/ou SRM des signaux de réponse ayant été détectés par l'ensemble de mesure et du signal de référence IRM et/ou SRM émis, ayant été détecté par l'ensemble de mesure, au moins une image comportant :
   - une représentation visuelle correspondant au corps à étudier ou à une partie de celui-ci,
   - l'objet virtuel d'IRM et/ou de SRM représenté par le signal prescrit d'objet virtuel, cet objet virtuel étant distinct de la représentation visuelle du corps ou de la partie du corps,
- le module de commande de stimulation étant connecté à un module de stimulation sensorielle du corps étant un être vivant pour la fourniture à ce dernier du signal temporel de stimulation extérieur, le module de stimulation sensorielle étant apte à émettre au moins une stimulation sensorielle, autre que les signaux d'excitation IRM et/ou SRM, à destination du corps en fonction du signal temporel de stimulation extérieur.

Un cinquième objet de l'invention est un procédé d'imagerie IRM et/ou SRM, tel que défini par la revendication 18, dans lequel
- on émet, par un ensemble de mesure d'IRM et/ou de SRM, des signaux d'excitation IRM et/ou SRM dans un volume d'examen dans lequel se trouve un corps à étudier,
caractérisé en ce que
- l'on envoie, par un module de commande de stimulation, un signal temporel de stimulation extérieur à une deuxième entrée de réception du module de production tel que décrit ci-dessus et à un module de stimulation sensorielle, lequel, émet au moins une stimulation sensorielle, autre que les signaux d'excitation IRM et/ou SRM, à destination du corps en fonction du signal temporel de stimulation extérieur,
- l'on envoie, par l'ensemble de mesure d'IRM et/ou de SRM, à une première entrée de réception du module de production, un signal de synchronisation IRM et/ou SRM,
- on produit un signal de référence IRM et/ou SRM par le module de production en fonction du signal temporel de stimulation extérieur, en fonction du signal de synchronisation IRM et/ou SRM et en fonction du signal prescrit d'objet virtuel présent dans le module de production,
- on émet par au moins une antenne d'émission, qui est distincte de l'ensemble de mesure et qui est connectée au module de production, le signal de référence IRM et/ou SRM,
- on détecte, par l'ensemble de mesure, des signaux de réponse IRM et/ou SRM émis par le corps en réponse aux signaux d'excitation et on détecte par l'ensemble de mesure le signal de référence IRM et/ou SRM ayant été émis par l'antenne d'émission,
- on génère par un module de commande, connecté à l'ensemble de mesure, par traitement IRM et/ou SRM des signaux de réponse ayant été détectés par l'ensemble de mesure et du signal de référence IRM et/ou SRM émis, ayant été détecté par l'ensemble de mesure, au moins une image comportant :
   - une représentation visuelle correspondant au corps à étudier ou à une partie de celui-ci,
   - l'objet virtuel d'IRM et/ou de SRM représenté par le signal prescrit d'objet virtuel, cet objet virtuel étant distinct de la représentation visuelle du corps ou de la partie du corps.

Un sixième objet de l'invention est un programme d'ordinateur, comportant des instructions pour la mise en œuvre du procédé d'imagerie IRM et/ou SRM tel que décrit ci-dessus, lorsqu'il est mis en œuvre sur un calculateur.

L'invention sera mieux comprise à la lecture de la description qui va suivre, donnée uniquement à titre d'exemple non limitatif en référence aux dessins annexés, sur lesquels :
- la figure 1 est une vue schématique d'un dispositif d'imagerie IRM et/ou SRM, dans lequel peut être utilisé un module de production d'un signal de référence IRM et/ou SRM, suivant un mode de réalisation de l'invention ;
- la figure 2 est une vue schématique d'un module 6 de production d'un signal de référence, suivant un mode de réalisation de l'invention ;
- la figure 3 représente un exemple d'images IRM obtenues par le module de production suivant un mode de réalisation de l'invention ;
- les figures 4 à 12 représentent des chronogrammes de signaux apparaissant dans le dispositif d'imagerie IRM et/ou SRM suivant un mode de réalisation de l'invention ;
- la figure 13 représente un organigramme d'un procédé suivant un mode de réalisation de l'invention,
- la figure 14 représente un exemple de spectre SRM obtenu par le module de production SRM suivant un mode de réalisation de l'invention.

On décrit ci-dessous d'abord d'une manière générale un dispositif 1 d'imagerie IRM et/ou SRM, dans lequel peut être utilisé le module 6 de production d'un signal S0 de référence IRM et/ou SRM suivant l'invention.

Le signal S0 de référence est un signal contrôlé, par exemple radiofréquence, ayant les caractéristiques d'un signal IRM et/ou SRM. Le signal S0 de référence est apte à être lu par un dispositif 1 d'imagerie IRM et/ou SRM, à savoir par les éléments 22 de détection de ce dernier.

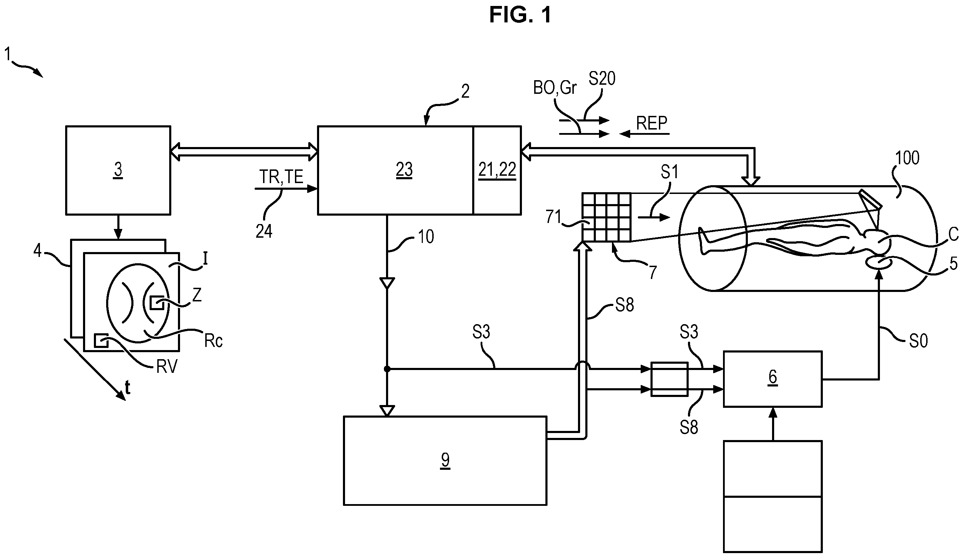

A la figure 1, le dispositif 1 d'imagerie IRM et/ou SRM, pouvant être prévu pour former au moins une image ou un spectre d'un objet C ou corps C à étudier (désigné globalement ci-dessous par corps C), comporte un ensemble 2 de mesure, servant à l'émission de signaux d'excitation IRM et/ou SRM dans un volume d'examen dans lequel se trouve le corps C. Cet ensemble 2 de mesure sert également à la détection de signaux REP de réponse IRM et/ou SRM émis par le corps en réponse aux signaux d'excitation IRM et/ou SRM.

Il est connu par l'homme du métier que les signaux d'excitation IRM et/ou SRM comportent un champ magnétique de polarisation intense B0 de quelques dixièmes de tesla à quelques teslas, par exemple de 0,1 à 5 T, des gradients Gr de champ magnétique et un signal radiofréquence S20 d'excitation électromagnétique, pouvant comprendre des impulsions électromagnétiques S20 de radiofréquence, afin d'exciter des molécules dans le corps C situé dans le volume d'examen 100. Les signaux d'excitation B0, S20, Gr sont émis à l'aide d'éléments d'émission 21, pouvant comprendre un ou plusieurs aimants et/ou une ou plusieurs bobines pour l'émission du champ magnétique B, et une ou plusieurs antennes pour l'émission du signal radiofréquence S20 d'excitation.

L'ensemble 2 de mesure comporte en outre des éléments 22 de détection des signaux de réponse IRM et/ou SRM. Ces éléments 22 de détection peuvent comprendre la ou les même(s) antenne(s) que la ou les antenne(s) émettrice(s) des éléments 21 d'émission, qui sont alors à la fois émettrices et réceptrices, ou une ou plusieurs autres antennes réceptrices.

Suivant un mode de réalisation, l'ensemble 2 de mesure comporte une sortie 10 de fourniture d'un signal S3 de synchronisation d'IRM et/ou SRM.

On décrit ci-dessous :
- d'abord le module 6 de production dans le cas général de l'IRM et/ou SRM,
- le procédé de production du signal S0 de référence IRM et/ou SRM (et programme correspondant),
- le dispositif 1 d'imagerie IRM et/ou SRM utilisant le module 6 de production,
- le procédé d'imagerie IRM et/ou SRM utilisant le module 6 de production (et programme correspondant).

### Module de production IRM et/ou SRM

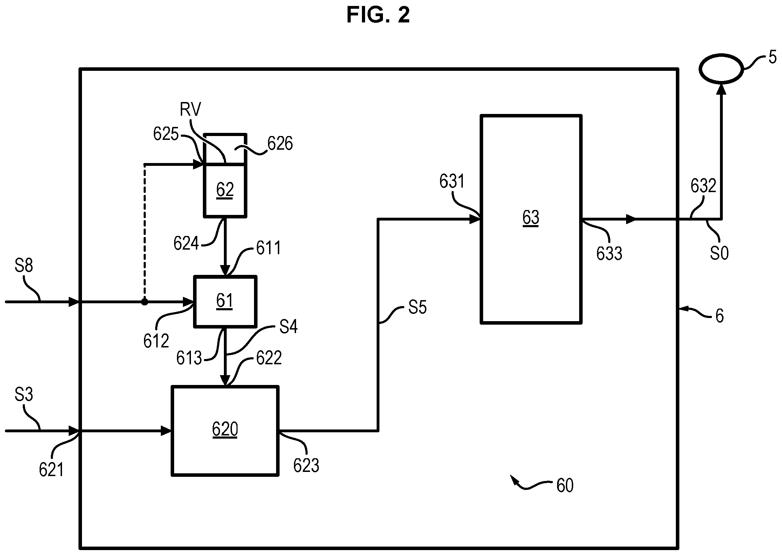

Suivant l'invention, à la figure 2, le module 6 de production d'un signal S0 de référence IRM et/ou SRM, comporte :
- une première entrée 621 de réception d'un signal S3 de synchronisation IRM et/ou SRM,
- une deuxième entrée 612 de réception d'un signal temporel S8 de stimulation extérieur,
- un moyen 62 de fourniture d'un signal RV prescrit représentant un objet virtuel RVV d'IRM et/ou de SRM,
- un moyen 60 de génération du signal S0 de référence IRM et/ou SRM par utilisation du signal S3 de synchronisation IRM et/ou SRM avec le signal temporel S8 de stimulation extérieur et avec le signal RV prescrit d'objet virtuel d'IRM et/ou de SRM, pour faire varier temporellement le signal S0 de référence IRM et/ou SRM de la même manière qu'une caractéristique temporelle déterminée du signal temporel S8 de stimulation extérieur et en synchronisation avec le signal S3 de synchronisation IRM et/ou SRM,
- une première sortie 632 de fourniture du signal S0 de référence IRM et/ou SRM.

Cette caractéristique temporelle déterminée peut être par exemple la fréquence de variation du signal temporel S8 de stimulation extérieur et/ou un instant de départ du signal temporel S8 de stimulation extérieur. Suivant un mode de réalisation, le moyen 62 de fourniture d'un signal RV prescrit représentant un objet virtuel RVV d'IRM et/ou de SRM comporte une mémoire 626, dans laquelle est enregistrée comme signal RV prescrit représentant un objet virtuel RVV d'IRM et/ou de SRM une transformée de Fourier de l'objet virtuel RVV, cette transformée de Fourier étant dans l'espace des k, ou une représentation dans l'espace des k réciproque de l'objet virtuel. Le moyen 62 de fourniture comporte une quatrième sortie 624 sur laquelle il envoie l'objet virtuel RVV d'IRM et/ou de SRM de la mémoire 626.

Bien entendu, chaque transformée de Fourier peut être remplacée par une représentation dans l'espace des k réciproque de l'objet virtuel.

Il peut être enregistré dans la mémoire 626 une multiplicité de transformées de Fourier de respectivement une multiplicité d'objets virtuels RVV distincts en amplitude et/ou forme et/ou position dans l'espace des k.

Suivant un mode de réalisation, le moyen 62 de fourniture d'un signal RV prescrit représentant un objet virtuel RVV d'IRM et/ou de SRM comporte une sixième entrée 625 de réception du signal temporel S8 de stimulation extérieur, pour envoyer sur la quatrième sortie 624 successivement la pluralité de transformées de Fourier en synchronisation avec le signal temporel S8 de stimulation extérieur présent sur la sixième entrée 625. La sixième entrée 625 est par exemple connectée à la première entrée 612, ainsi que cela est représenté par les traits interrompus à la figure 2. Suivant un mode de réalisation, le moyen 60 de génération comporte un élément 61 de multiplication du signal prescrit RV d'objet virtuel (ou d'un signal obtenu à partir au moins du signal prescrit RV) par le signal temporel S8 de stimulation extérieur.

Suivant un mode de réalisation, le moyen de génération comporte un élément 63 de transposition fréquentielle du signal prescrit RV d'objet virtuel (ou d'un signal obtenu à partir au moins du signal prescrit RV) à une fréquence déterminée d'IRM et/ou de SRM.

Suivant un mode de réalisation, la fréquence déterminée est la fréquence de Larmor d'IRM et/ou de SRM. Dans un mode de réalisation, cette fréquence déterminée est comprise entre 1 MHz et 1 GHz, notamment entre 10 MHz et 100 MHz. Elle peut être par exemple de 64 MHz.

Suivant un mode de réalisation, le moyen 60 de génération comporte un élément 620 de déclenchement du signal prescrit RV d'objet virtuel (ou d'un signal obtenu à partir au moins du signal prescrit RV) une pluralité de fois successives selon un séquencement déterminé en fonction du signal S3 de synchronisation IRM et/ou SRM.

Suivant un mode de réalisation, la sortie 632 est reliée à une antenne 5 d'émission du signal S0 de référence IRM et/ou SRM.

Suivant un mode de réalisation, la première entrée 621 de réception est connectée à la sortie 10 de fourniture du signal S3 de synchronisation d'IRM et/ou SRM.

Suivant un mode de réalisation, la deuxième entrée 612 de réception est connectée à un module 9 de commande de stimulation fournissant le signal S8 temporel de stimulation extérieur.

Suivant un mode de réalisation, l'élément 61 de multiplication comporte, en plus de la deuxième entrée 612 de réception du signal temporel S8 de stimulation extérieur, une troisième entrée 611 de réception du signal prescrit RV d'objet virtuel (ou d'un signal obtenu à partir au moins du signal prescrit RV) et une deuxième sortie 613 de fourniture du produit du signal S8 présent sur la deuxième entrée 612 par le signal présent sur la troisième entrée 611.

Suivant un mode de réalisation, l'élément 620 de déclenchement comporte, en plus de la première entrée 621 de réception d'un signal S3 de synchronisation IRM et/ou SRM, une quatrième entrée 622 de réception du signal prescrit RV d'objet virtuel (ou d'un signal obtenu à partir au moins du signal prescrit RV) et une troisième sortie 623 de fourniture du signal présent sur la quatrième entrée 622, séquencé la pluralité de fois successives selon le séquencement déterminé en fonction du signal S3 présent sur la première entrée 621. La première entrée 621 est connectée à la sortie 10 pour recevoir ce signal S3 de synchronisation d'IRM et/ou SRM.

Suivant un mode de réalisation, l'élément 63 de transposition fréquentielle à une fréquence déterminée d'IRM et/ou de SRM comporte une cinquième entrée 631 de réception du signal prescrit RV d'objet virtuel (ou d'un signal obtenu à partir au moins du signal prescrit RV) pour fournir sur sa cinquième sortie 633 la transposition fréquentielle du signal présent sur son entrée 631.

Suivant un mode de réalisation, représenté à la figure 2, la troisième entrée 611 est connectée à la sortie 624 du moyen 62 de fourniture du signal RV prescrit représentant l'objet virtuel d'IRM et/ou de SRM, la quatrième entrée 622 est connectée à la deuxième sortie 613, la troisième sortie 623 est connectée à la cinquième entrée 631, et la cinquième sortie 633 forme la première sortie 632 de fourniture du signal S0 de référence IRM et/ou SRM.

### Cas de l'IRM :

On décrit ci-dessous un premier cas d'un signal S0 de référence IRM, d'un signal S3 de synchronisation IRM et d'un signal RV prescrit représentant un objet virtuel RVV d'IRM.

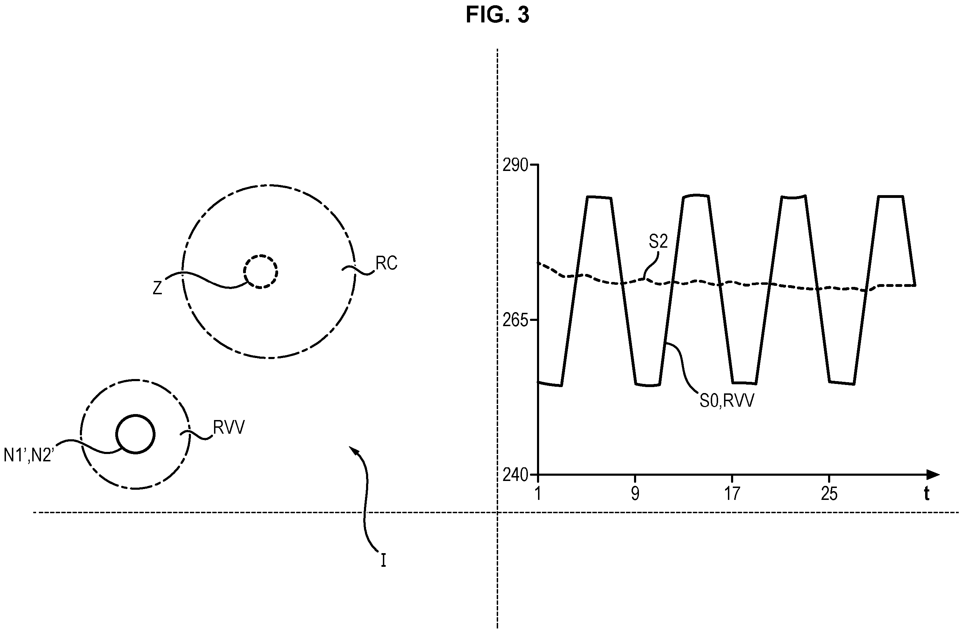

Ce premier cas est représenté à titre d'exemple aux figures 3, 10, 11 et 12.

Dans un mode de réalisation, le séquencement déterminé est un séquencement du type EPI pour le signal S3 de synchronisation IRM, l'objet virtuel d'IRM et le signal S0 de référence IRM.

Suivant un mode de réalisation, l'objet virtuel RVV d'IRM est une représentation visuelle d'IRM dans une image d'IRM.

Suivant un mode de réalisation, le séquencement déterminé est un retard du signal prescrit RV d'objet virtuel par un temps d'écho TE - Δ extrait du signal S3 de synchronisation IRM, pour l'objet virtuel RVV d'IRM et pour le signal S0 de référence IRM. Ce mode de réalisation est représenté à la figure 2.

### Cas de la SRM :

On décrit ci-dessous un deuxième cas d'un signal S0 de référence SRM, d'un signal S3 de synchronisation SRM et d'un signal RV prescrit représentant un objet virtuel RVV de SRM.

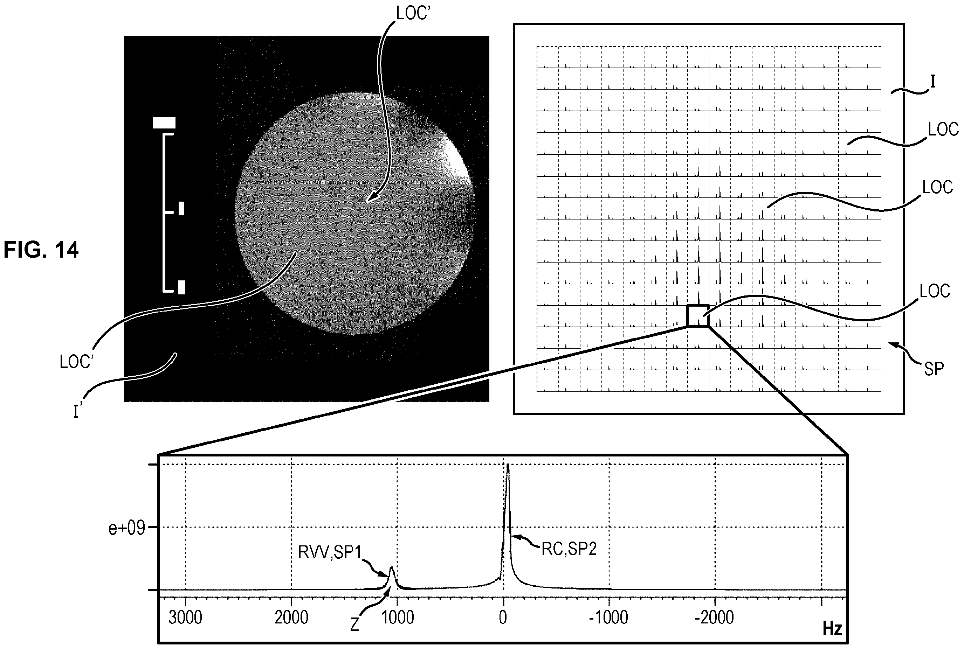

Ce deuxième cas est représenté à titre d'exemple à la figure 14.

Dans un mode de réalisation, l'objet virtuel RVV de SRM est un premier spectre virtuel SP1 de SRM. Ainsi, dans ce cas, le signal RV prescrit représentant l'objet virtuel RVV de SRM est un signal temporel qui est la transformée de Fourier inverse du premier spectre virtuel SP1 de SRM.

### Fonctionnement du module 6 de production IRM et/ou SRM

Le fonctionnement du module 6 de production est d'abord expliqué ci-dessous en référence au mode de réalisation de la figure 2 et aux figures 3 à 12, dans le premier cas de l'IRM.

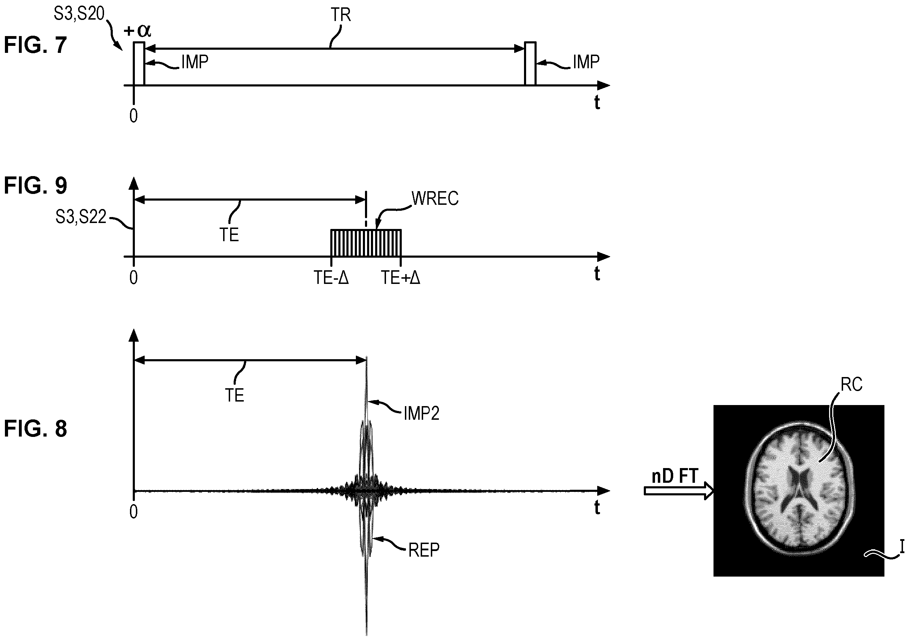

La figure 7 montre un exemple de signal radiofréquence S20 d'excitation électromagnétique, émis par l'ensemble 2 de mesure vers l'être vivant C dans le volume 100 d'examen ou à proximité de celui-ci, en fonction du temps t en abscisse, dans le cas de l'IRM. Ce signal radiofréquence S20 d'excitation a, par exemple, une période TR. A la figure 7, le signal S20 est de forme impulsionnelle avec la période TR entre deux impulsions IMP successives. Ce signal S20 d'excitation provoque, au bout d'un temps TE d'écho, l'apparition du signal de réponse REP émis par l'être vivant C, ainsi que cela est illustré à la figure 8, le temps TE étant le temps écoulé entre le signal REP de réponse et le début de chaque impulsion IMP, repéré par l'instant 0 aux figures 7 à 12. Ce signal de réponse REP est radiofréquence.

Les éléments 22 de détection de l'ensemble 2 de mesure possèdent une fenêtre WREC de réception des signaux REP de réponse IRM et/ou SRM, pendant lesquels ils sont actifs, qui est décalée du temps TE d'écho par rapport au signal S20, c'est-à-dire par rapport au début de chaque impulsion IMP, ainsi que cela est illustré à la figure 9 représentant les signaux S22 d'acquisition des éléments 22 de détection, ayant cette fenêtre WREC. Cette fenêtre WREC de réception est par exemple centrée autour du temps TE, c'est-à-dire que la fenêtre WREC commence au temps TE-Δ et finit au temps TE+Δ, où Δ est une durée positive déterminée, non nulle inférieure à TE, pour ainsi pouvoir recevoir le signal REP de réponse sous la forme impulsionnelle IMP2 centrée sur le temps TE, afin que cette impulsion IMP2 des signaux REP de réponse soit en grande partie comprise dans la fenêtre WREC pour pouvoir être reçue par l'ensemble 2 de mesure à la figure 8. Les moyens 23 (ou nD FT) de traitement présents dans l'ensemble 2 de mesure sont configurés pour produire, à partir des signaux REP de réponse la représentation RC de l'être vivant C. Cette représentation RC peut être visuelle ou spectrale.

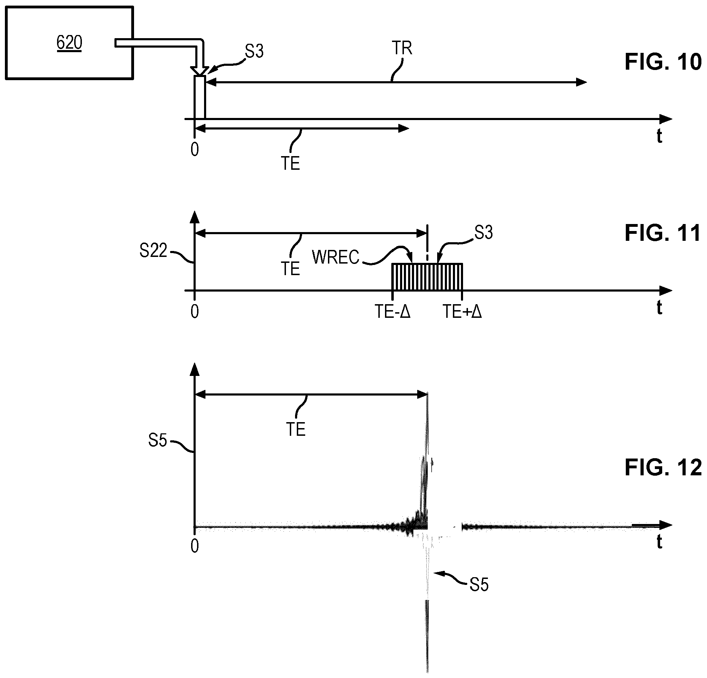

Suivant un mode de réalisation, le signal S3 de synchronisation comporte une information sur le temps TE d'écho et une information sur le temps TR de répétition du signal S20 d'excitation radiofréquence et/ou une information sur le positionnement de la fenêtre WREC de réception, ainsi que cela est représenté à titre d'exemple à la figure 10. Le signal S3 de synchronisation peut être formé par exemple par les signaux S20 et S22 ou par une combinaison de ceux-ci. Le signal S3 de synchronisation est apte à déclencher la réception des signaux REP et S0 pendant la fenêtre WREC de réception par l'ensemble 2 de mesure après le temps d'écho TE calé sur la période TR de répétition. Les temps TR et TE sont prescrits. L'ensemble 2 de mesure peut comporter une entrée 24 de prescription pour entrer et prescrire les temps TR et TE, les moyens de traitement 23 et les éléments 21 et 22 étant déclenchés en fonction de ces temps TR et TE.

L'élément 620 de déclenchement fournit sur sa sortie 623 un signal S5 qui est décalé temporellement du temps TE d'écho par rapport au signal S4 de son entrée 622. De cette manière, ainsi qu'on le voit à la figure 12, le signal S5 comporte une version du signal RV, qui est retardée du temps TE d'écho de la même manière que les signaux REP de réponse de l'être vivant C. Ainsi, le signal S8 de stimulation peut être acquis par l'ensemble 2 de mesure dans la même fenêtre WREC de réception que les signaux REP de réponse de l'être vivant C.

Le module 63 fournit sur sa sortie 632 le signal S0 de référence, qui est alors envoyé à l'antenne 5 d'émission.

L'antenne 5 d'émission est située dans le volume 100 d'examen ou à côté du volume 100 d'examen ouvert. Cette antenne 5 d'émission est distincte de l'ensemble 2 de mesure et est donc distincte des éléments 21 d'émission. L'antenne 5 d'émission sert à l'émission des signaux S0 de référence IRM et/ou SRM dans le volume 100 d'examen. Ainsi, l'antenne 5 d'émission est distincte notamment de la ou des antenne(s) émettrice(s) ou de la ou des antenne(s) émettrice(s)-réceptrice(s) comprise(s) dans les éléments 21, 22 de l'ensemble 2 de mesure. L'antenne 5 d'émission peut être formée par exemple par une bobine radiofréquence.

Le volume 100 d'examen comporte par exemple habituellement ce que l'on appelle un tunnel d'IRM. Bien entendu, le volume d'examen peut également être compris dans une structure ouverte.

Les signaux de référence S0, qui sont émis par l'antenne 5 d'émission, sont configurés pour être détectés par l'ensemble 2 de mesure, à savoir son ou ses élément(s) 22 de détection.

L'ensemble 2 de mesure est connecté à un module 3 de commande configuré pour générer, à partir des signaux REP de réponse ayant été détectés par l'ensemble 2 de mesure et à partir des signaux de référence S0 émis par l'élément 5, lesquels ont été également détectés par cet ensemble 2 de mesure, au moins une image I représentée aux figures 1, 3 et 8 (ou au moins un spectre SP représenté à la figure 14), comportant une représentation RC correspondant au corps C à étudier ou à une partie de celui-ci, ainsi que l'objet virtuel RVV correspondant au signal S0 de référence IRM (et/ou SRM). Le signal S0 de référence IRM (et/ou SRM), émis par l'antenne 5 d'émission et produit par le module 6, est en effet représentatif de cet objet virtuel RVV. L'objet virtuel RVV est distinct de la représentation RC du corps C ou de la partie du corps C dans l'image I (et/ou dans le spectre SP). Suivant un mode de réalisation, l'objet virtuel RVV peut être visuel dans le cas de l'IRM (ou spectral dans le cas de SRM).

Le dispositif 1 comporte optionnellement au moins un écran 4 de visualisation de la ou des image(s) I et/ou du spectre SP.

Le corps C peut être par exemple un être vivant, par exemple un être humain. Ainsi, le dispositif 1 est un dispositif d'imagerie IRM et/ou SRM pour former au moins une image I ou un spectre SP d'un être vivant C, par exemple d'un être humain. Le corps C pourrait également être un animal vivant C. Le corps C pourrait également être autre qu'un être vivant.

Suivant un mode de réalisation, le signal temporel S8 de stimulation extérieur est un signal S8 de commande de stimulation d'un être vivant C.

Suivant un mode de réalisation, le signal temporel S8 de stimulation extérieur comprend au moins un signal S8 de commande de stimulation sensorielle et/ou au moins un signal S8 de commande d'injection d'un produit de contraste.

Suivant l'invention, le dispositif 1 comporte en outre un module 7 externe de modulation d'un effet sur le corps C, cet effet étant apte à être détecté par l'ensemble 2 de mesure. Par exemple, le dispositif 1 comporte comme module 7 de modulation un module 7 de stimulation du corps C situé dans le volume 100 d'examen ou à proximité du volume d'examen.

Dans le cas d'une stimulation sensorielle, le module 7 de stimulation comporte un module 71 de stimulation sensorielle, qui est apte à émettre au moins une stimulation sensorielle S1 dans le volume 100 d'examen à destination du corps C en fonction d'au moins le signal S8 de stimulation fourni au module 7 de stimulation par un module 9 de commande de stimulation. Ce module 7 de stimulation sensorielle est distinct des éléments 21 d'émission, la stimulation sensorielle étant différente des signaux B0, Gr, S20 d'excitation. Suivant un mode de réalisation, la stimulation sensorielle S1 est de l'un ou plusieurs des types suivants : visuelle, sonore, olfactive, haptique, musculaire, nerveuse, de motricité.

Dans le cas d'un signal S8 de commande d'injection d'un produit de contraste, le module 7 de stimulation comporte un module non représenté d'injection d'un produit de contraste dans le corps C ou dans l'objet C.

Suivant un mode de réalisation de l'invention, le module 6 de production du signal S0 de référence est configuré pour produire le signal S0 de référence IRM et/ou SRM qui correspond au signal S8 de stimulation, de telle sorte que la fréquence de modulation de l'intensité (ou de la forme caractéristique) de l'objet virtuel RVV présent dans l'image I (ou dans le spectre SP) soit asservie sur la fréquence de stimulation sensorielle S1. Ainsi, l'évolution périodique de l'intensité ou de la forme de l'objet virtuel RVV est asservie en fonction de la stimulation sensorielle S1. Ainsi suivant l'invention, on crée un objet virtuel RVV dont la forme et l'intensité peuvent varier au cours du temps, en synchronisation avec un signal extérieur S8.

Ainsi, l'invention incruste dans l'image I ou dans le spectre SP un objet virtuel RVV dont les caractéristiques en intensité ou en forme ou en position permettent de remonter à l'évolution temporelle de la stimulation sensorielle S1. Cela permet ainsi à un utilisateur de bien distinguer l'objet virtuel RVV par rapport à la représentation RC sur un écran.

L'invention permet ainsi d'obtenir une corrélation directe entre la stimulation S1 envoyée au corps C et l'effet produit par cette stimulation S1 dans la représentation RC du corps C.

Cette représentation RC peut être par exemple une vue en coupe du cerveau d'un être humain C, ainsi que cela est représenté aux figures 1 et 8, ou plus généralement une vue en coupe du cerveau d'un être vivant C dans le cas de l'IRM. Dans le cas SRM à la figure 14, la représentation visuelle RC du corps C ou d'une partie du corps C est un deuxième spectre SP2 (représentation spectrale RC). L'ensemble 2 de mesure et/ou le module 3 de commande sont configurés pour fournir une pluralité de deuxièmes spectres SP2 calculés pour respectivement une pluralité de parties LOC' d'une image I' d'IRM, ces parties LOC' étant par exemple des carrés ou des rectangles juxtaposés en lesquels l'image I' est divisée. Ainsi, chaque deuxième spectre SP2 d'une partie LOC de l'image I de SRM est la transformée de Fourier de la partie LOC' correspondante de l'image I' d'IRM. Le spectre SP de SRM comporte une pluralité de parties LOC correspondant dans leur localisation à la pluralité de parties LOC' de l'image I' d'IRM, ces parties LOC étant par exemple des carrés ou des rectangles juxtaposés en lesquels l'image I de SRM est divisée. Le premier spectre virtuel SP1 est superposé au deuxième spectre SP2 dans chaque partie LOC du spectre SP. Le spectre SP de SRM, comporte l'objet virtuel RVV de SRM (premier spectre SP1) et la représentation visuelle RC (deuxième spectre SP2) du corps C ou d'une partie du corps C.

Par exemple, l'objet virtuel RVV de SRM (ou spectre SP1) est ou comprend un pic caractéristique distinct de la représentation RC, afin qu'un utilisateur puisse bien distinguer l'objet virtuel RVV par rapport à la représentation RC sur un écran 4.

L'invention permet de résoudre le problème de l'IRM fonctionnelle ou de la SRM, dans lesquelles l'on ne sait pas rattacher les petites variations d'intensité localisées dans la représentation visuelle ou spectrale RC précisément à une cause en temps réel. Grâce à l'invention, le signal S0 de référence détecté par l'ensemble 2 de mesure reproduit directement la stimulation sensorielle S1 qui est la cause des petites variations d'intensité lumineuse localisées dans l'image I ou dans le spectre SP visualisé, par exemple dans une zone Z.

Le praticien qui observe les images I ou les spectres SP se succédant dans le temps peut ainsi faire la relation entre la stimulation sensorielle S1 et l'effet que cette stimulation sensorielle S1 produit dans la représentation visuelle ou spectrale RC de l'être vivant C dans l'image I ou dans le spectre SP.

L'un des avantages de l'invention est que, par rapport aux dispositifs d'IRM fonctionnelle ou de SRM connus, chaque image I ou spectre SP comporte un objet virtuel RVV calé sur la stimulation sensorielle S1.

A la figure 3 est représentée une image I comportant en plus de la représentation visuelle RC du corps C, dans laquelle se trouve la zone Z, l'objet virtuel RVV calé temporellement sur la stimulation sensorielle S1, distincte de la représentation visuelle RC.

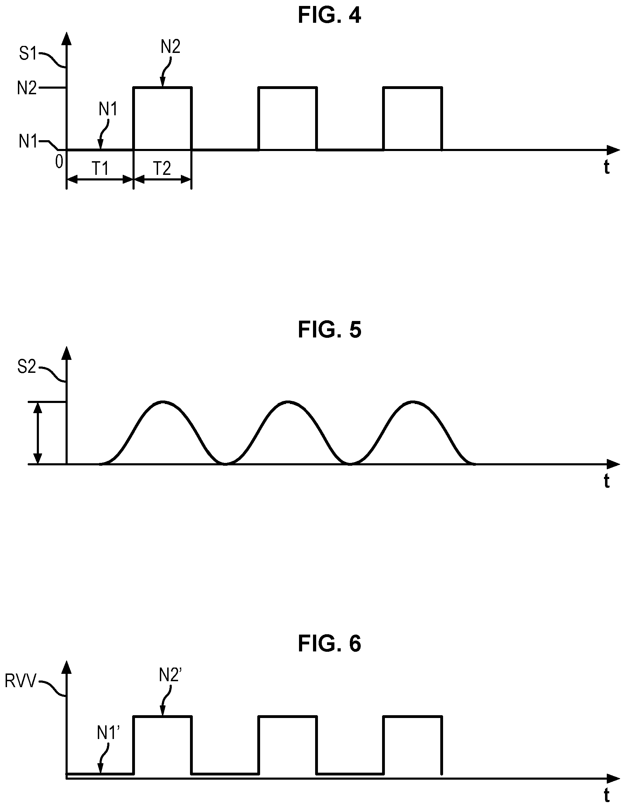

On suppose, par exemple, que la stimulation sensorielle S1 est une stimulation visuelle, comportant deux niveaux lumineux successifs différents N1 et N2, à savoir un premier niveau N1 pendant une durée T1, suivi d'un deuxième niveau N2 pendant une durée T2, ainsi que cela est représenté à la figure 4, montrant le signal S1 en ordonnées en fonction du temps t en abscisse. Le signal S1 de la figure 4 est, par exemple, périodique, chaque durée T1, T2 pouvant être de quelques secondes, par exemple de plus de 0,1 seconde, par exemple entre une seconde et une minute, et par exemple de 30 secondes. L'effet de cette stimulation S1 sur la représentation visuelle RC de l'être vivant est un signal S2 qui est une variation d'intensité lumineuse d'une ou plusieurs zones Z de l'être vivant C dans l'image I, qui sont faibles par rapport à la différence entre les pixels d'intensité lumineuse la plus haute et les pixels d'intensité lumineuse la plus basse présents dans la représentation visuelle RC de l'être vivant C, et pouvant être en général égales de 0,5 à 3 % de cette différence. Ce signal S2 est représenté à la figure 3 et d'une manière agrandie à la figure 5. Par conséquent, certains des pixels situés dans la zone Z de l'image I varient selon le signal S2 selon une amplitude de variation très faible, sans que l'on sache à l'avance où est située cette zone Z dans l'image I, le but étant justement de déterminer quelle zone Z de l'être vivant C est stimulée par la stimulation S1. Il y a par exemple une image I suivant une période déterminée, pouvant être par exemple toutes les 2 à 4 secondes.

Suivant un mode de réalisation correspondant à l'exemple de la figure 4, l'objet virtuel RVV obtenu dans l'image I varie temporellement suivant le profil de la figure 6. Ainsi, lorsque la stimulation sensorielle S1 est au niveau N1 bas pendant la durée T1, l'objet virtuel RVV a, d'une manière correspondante pendant cette durée T1 dans l'image I, par exemple un premier niveau d'intensité lumineuse N1', tandis que, lorsque la stimulation sensorielle S1 a le deuxième niveau N2 haut pendant la durée T2, l'objet virtuel RVV a pendant la durée T2 dans l'image I un deuxième niveau N2' différent du premier niveau N1'. L'objet virtuel RVV est ou comprend par exemple une région distincte de la représentation visuelle RC du corps, telle que par exemple un cercle dans l'image I d'IRM.

A la figure 3, la comparaison visuelle des niveaux N1', N2' changeant dans le temps dans l'objet virtuel RVV présent dans l'image I, permet de synchroniser la représentation visuelle RC de l'être vivant C avec la stimulation sensorielle S1 qui lui est envoyée, ce qui permet au praticien de mieux distinguer et de mieux interpréter les variations d'intensité lumineuse de la zone Z de l'être vivant C ou les mouvements et les déformations de cette zone Z dans l'image I. Dans l'image I peut également être présent un chronogramme des signaux S2 et S0 (ou RV), avec la même échelle de temps t ou le même axe des temps t.

Ainsi, suivant un mode de réalisation, le module 6 de production, le module 9 de commande de stimulation et l'ensemble 2 de mesure sont configurés pour que, dans l'image I, l'objet virtuel RVV varie avec la même horloge temporelle que celle de la stimulation sensorielle S1 émise par le module 7 de stimulation sensorielle.

Suivant un mode de réalisation, le module 6 de production, le module 9 de commande de stimulation et l'ensemble 2 de mesure sont configurés pour que, dans l'image I, la représentation visuelle RC correspondant à l'être vivant C et l'objet virtuel RVV sont synchronisés sur la stimulation sensorielle S1 émise par le module 7 de stimulation sensorielle.

Procédé de production d'un signal de référence IRM et/ou SRM

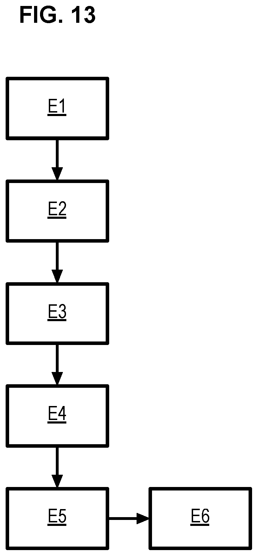

L'invention concerne également un procédé de production du signal S0 de référence IRM et/ou SRM, à l'aide du module 6 de production. Les étapes de ce procédé sont représentées à la figure 13.

Au cours d'une étape E2, l'on envoie par le module 9 de commande de stimulation à la deuxième entrée 612 de réception le signal temporel S8 de stimulation extérieur.

Au cours d'une étape E3, l'on envoie, par l'ensemble (2) de mesure d'IRM et/ou de SRM, à la première entrée 621 de réception le signal (S3) de synchronisation IRM et/ou SRM.

Au cours de l'étape E3, le moyen (62) de fourniture fournit le signal RV prescrit représentant un objet virtuel RVV d'IRM et/ou de SRM.

Au cours d'une étape E4, le moyen de génération, faisant partie du module 6 de production, utilise le signal S3 de synchronisation IRM et/ou SRM, le signal temporel S8 de stimulation extérieur et le signal RV prescrit d'objet virtuel d'IRM et/ou de SRM, pour générer le signal (S0) de référence IRM et/ou SRM, de telle sorte que le signal S0 de référence IRM et/ou SRM varie temporellement de la même manière qu'une caractéristique temporelle déterminée du signal temporel S8 de stimulation extérieur et en synchronisation avec le signal S3 de synchronisation IRM et/ou SRM.

Au cours de l'étape E4, la sortie 632 de fourniture fournit le signal S0 de référence IRM et/ou SRM.

### Programme d'ordinateur de production du signal S0 de référence IRM et/ou SRM

L'invention concerne également un programme d'ordinateur, comportant des instructions pour la mise en œuvre du procédé de production du signal S0 de référence IRM et/ou SRM, lorsqu'il est mis en œuvre sur un calculateur. Ce programme d'ordinateur peut être enregistré dans le module 6 de production.

### Dispositif d'imagerie IRM et/ou SRM utilisant le module de production

L'invention concerne également un dispositif d'imagerie IRM et/ou SRM, comportant :
- un ensemble 2 de mesure d'IRM et/ou de SRM, servant à l'émission des signaux B0, S20, Gr d'excitation IRM et/ou SRM dans le volume 100 d'examen dans lequel se trouve un corps C à étudier et à la détection des signaux REP de réponse IRM et/ou SRM émis par le corps C en réponse à ces signaux B0, S20, Gr d'excitation,
caractérisé en ce que le dispositif comporte en outre :
- le module 6 de production du signal S0 de référence IRM et/ou SRM, dont la première entrée 621 de réception est connectée à la sortie 10 de fourniture du signal S3 de synchronisation IRM et/ou SRM de l'ensemble 2 de mesure, et dont la deuxième entrée 612 de réception est connectée au module 9 de commande de stimulation fournissant le signal S8 temporel de stimulation extérieur,
- une antenne 5 d'émission, qui est distincte de l'ensemble 2 de mesure et qui est connectée au module 6 de production pour émettre le signal S0 de référence IRM et/ou SRM, de telle sorte que le signal S0 de référence IRM et/ou SRM ayant été émis par l'antenne 5 d'émission soit détectable par l'ensemble 2 de mesure,
- un module 3 de commande, connecté à l'ensemble 2 de mesure et configuré pour générer, par traitement IRM et/ou SRM des signaux de réponse ayant été détectés par l'ensemble 2 de mesure et du signal S0 de référence IRM et/ou SRM émis, ayant été détecté par l'ensemble 2 de mesure, au moins une image comportant :
   - la représentation visuelle RC correspondant au corps C à étudier ou à une partie de celui-ci,
   - l'objet virtuel RVV d'IRM et/ou de SRM représenté par le signal prescrit RV d'objet virtuel, cet objet virtuel RVV étant distinct de la représentation visuelle du corps C ou de la partie du corps,
- le module 9 de commande de stimulation étant connecté au module 71 de stimulation sensorielle du corps C étant un être vivant pour la fourniture à ce dernier du signal S8 temporel de stimulation extérieur, le module 71 de stimulation sensorielle étant apte à émettre au moins une stimulation sensorielle S1, autre que les signaux B0, S20, Gr d'excitation IRM et/ou SRM, à destination du corps C en fonction du signal S8 temporel de stimulation extérieur.

### Procédé d'imagerie IRM et/ou SRM

L'invention concerne également un procédé d'imagerie IRM et/ou SRM utilisant le module de production. Les étapes de ce procédé sont représentées à la figure 13.

Au cours d'une étape E1, on émet par l'ensemble 2 de mesure d'IRM et/ou de SRM, les signaux B0, S20, Gr d'excitation IRM et/ou SRM dans le volume 100 d'examen dans lequel se trouve le corps C à étudier.

Au cours d'une étape E2, on envoie, par le module 9 de commande de stimulation, le signal S8 temporel de stimulation extérieur à la deuxième entrée 612 de réception du module 6 de production et au module 71 de stimulation sensorielle, lequel, émet E2 au moins une stimulation sensorielle S1, autre que les signaux B0, S20, Gr d'excitation IRM et/ou SRM, à destination du corps C en fonction du signal S8 temporel de stimulation extérieur.

Au cours d'une étape E3, l'on envoie, par l'ensemble 2 de mesure d'IRM et/ou de SRM, à la première entrée 621 de réception du module 6 de production, le signal S3 de synchronisation IRM et/ou SRM.

Au cours d'une étape E4, on produit le signal S0 de référence IRM et/ou SRM par le module 6 de en fonction du signal S8 temporel de stimulation extérieur, en fonction du signal S3 de synchronisation IRM et/ou SRM et en fonction du signal prescrit RV d'objet virtuel présent dans le module 6 de production,

Au cours de l'étape E4, on émet par la au moins une antenne 5 d'émission, qui est distincte de l'ensemble 2 de mesure et qui est connectée au module 6 de production, le signal S0 de référence IRM et/ou SRM.

Au cours d'une étape E5, on détecte, par l'ensemble 2 de mesure, les signaux REP de réponse IRM et/ou SRM émis par le corps C en réponse aux signaux B0, S20, Gr d'excitation et on détecte par l'ensemble 2 de mesure le signal S0 de référence IRM et/ou SRM ayant été émis par l'antenne 5 d'émission.

Au cours d'une étape E6, on génère par le module 3 de commande, connecté à l'ensemble 2 de mesure, par traitement IRM et/ou SRM, des signaux REP de réponse ayant été détectés par l'ensemble 2 de mesure et du signal S0 de référence IRM et/ou SRM émis, ayant été détecté par l'ensemble 2 de mesure, au moins une image (I, SP) comportant :
- une représentation visuelle RC correspondant au corps C à étudier ou à une partie de celui-ci,
- l'objet virtuel RVV d'IRM et/ou de SRM représenté par le signal prescrit RV d'objet virtuel, cet objet virtuel RVV étant distinct de la représentation visuelle RC du corps C ou de la partie du corps.

### Programme d'ordinateur d'imagerie IRM et/ou SRM

L'invention concerne également un programme d'ordinateur, comportant des instructions pour la mise en œuvre du procédé d'imagerie IRM et/ou SRM, lorsqu'il est mis en œuvre sur un calculateur. Ce programme d'ordinateur peut être enregistré dans le dispositif 1 d'imagerie IRM et/ou SRM.

Suivant un mode de réalisation, on visualise (étape E6) sur au moins un écran 4 de visualisation l'image I.

Suivant un mode de réalisation, le module 6 de production du signal S0 de référence IRM et/ou SRM est configuré pour produire le signal S0 de référence IRM et/ou SRM correspondant au signal S8 de commande de stimulation, de telle sorte que l'objet virtuel RVV présent dans l'image I soit asservi sur la stimulation sensorielle S1.

Bien entendu, l'ordre des éléments 61, 620 et 63 à la figure 2 peut être permuté, ce qui est indiqué par l'expression « signal obtenu à partir au moins du signal prescrit RV » dans ce qui précède.

Ainsi, suivant un autre mode de réalisation, la quatrième entrée 622 est connectée à la sortie 624 du moyen 62 de fourniture du signal RV prescrit représentant l'objet virtuel RVV d'IRM et/ou de SRM, la troisième entrée 611 est connectée à la troisième sortie 623, la deuxième sortie 613 est connectée à la cinquième entrée 631 et la cinquième sortie 633 forme la première sortie 632 de fourniture du signal S0 de référence IRM et/ou SRM.

Suivant encore un autre mode de réalisation, la quatrième entrée 622 est connectée à la sortie 624 du moyen 62 de fourniture du signal RV prescrit représentant l'objet virtuel RVV d'IRM et/ou de SRM, la troisième sortie 623 est connectée à la cinquième entrée 631, la sortie 633 est connectée à la troisième entrée 611 et la deuxième sortie 613 est connectée à l'élément 5 d'émission et forme la sortie de fourniture du signal S0 de référence IRM et/ou SRM.

Bien entendu, les modes de réalisation décrits ci-dessus peuvent être combinés entre eux.

## Revendications

1. Module (6) de production d'un signal (S0) de référence IRM et/ou SRM, le module comportant :
- une première entrée (621) de réception d'un signal (S3) de synchronisation IRM et/ou SRM,
- un moyen (62) de fourniture d'un signal (RV) prescrit représentant un objet virtuel (RVV) d'IRM et/ou de SRM,
- un moyen de génération du signal (S0) de référence IRM et/ou SRM par utilisation du signal (S3) de synchronisation IRM et/ou SRM avec le signal (RV) prescrit d'objet virtuel d'IRM et/ou de SRM,
- une sortie (632) de fourniture du signal (S0) de référence IRM et/ou SRM,
**caractérisé en ce que**
le module comporte une deuxième entrée (612) de réception d'un signal temporel (S8) de stimulation extérieur,
le moyen de génération du signal (S0) de référence IRM et/ou SRM est configuré pour utiliser le le signal temporel (S8) de stimulation extérieur pour faire varier temporellement le signal (S0) de référence IRM et/ou SRM de la même manière qu'une caractéristique temporelle déterminée du signal temporel (S8) de stimulation extérieur et en synchronisation avec le signal (S3) de synchronisation IRM et/ou SRM.

2. Module (6) de production d'un signal (S0) de référence IRM et/ou SRM suivant la revendication 1, **caractérisé en ce que** le moyen (62) de fourniture d'un signal (RV) prescrit représentant un objet virtuel (RVV) d'IRM et/ou de SRM comporte une mémoire (626) dans laquelle est enregistré comme signal (RV) prescrit représentant un objet virtuel (RVV) d'IRM et/ou de SRM une transformée de Fourier, dans l'espace des k, de l'objet virtuel (RVV) ou une représentation dans l'espace des k réciproque de l'objet virtuel (RVV).

3. Module (6) de production d'un signal (S0) de référence IRM et/ou SRM suivant la revendication 2, **caractérisé en ce que** dans la mémoire est enregistrée une multiplicité de transformées de Fourier de respectivement une multiplicité d'objets virtuels (RVV) distincts dans l'espace des k ou une multiplicité de représentations dans l'espace des k réciproque d'une multiplicité d'objets virtuels (RVV) distincts, les transformées de Fourier ou les représentations dans l'espace des k réciproque d'une multiplicité d'objets virtuels (RVV) distincts ayant des amplitudes distinctes les unes des autres et/ou des formes distinctes les unes des autres et/ou des positions distinctes les unes des autres.

4. Module (6) de production d'un signal (S0) de référence IRM et/ou SRM suivant l'une quelconque des revendications précédentes, **caractérisé en ce que** le moyen de génération comporte un élément (61) de multiplication du signal prescrit (RV) d'objet virtuel ou d'un signal obtenu à partir au moins du signal prescrit (RV) d'objet virtuel par le signal temporel (S8) de stimulation extérieur.

5. Module (6) de production d'un signal (S0) de référence IRM et/ou SRM suivant l'une quelconque des revendications précédentes, **caractérisé en ce que** le moyen de génération comporte un élément (63) de transposition fréquentielle du signal prescrit (RV) d'objet virtuel ou d'un signal obtenu à partir au moins du signal prescrit (RV) d'objet virtuel à une ou plusieurs fréquences déterminées d'IRM et/ou de SRM.

6. Module (6) de production d'un signal (S0) de référence IRM et/ou SRM suivant la revendication précédente, **caractérisé en ce que** la fréquence déterminée est la fréquence de Larmor d'IRM et/ou de SRM.

7. Module (6) de production d'un signal (S0) de référence IRM et/ou SRM suivant l'une quelconque des revendications précédentes, **caractérisé en ce que** la sortie (632) est reliée à une antenne (5) d'émission du signal (S0) de référence IRM et/ou SRM.

8. Module (6) de production d'un signal (S0) de référence IRM et/ou SRM suivant l'une quelconque des revendications précédentes, **caractérisé en ce que** le signal (S8) de stimulation est un signal (S8) de commande de stimulation d'un être vivant (C).

9. Module (6) de production d'un signal (S0) de référence IRM et/ou SRM suivant l'une quelconque des revendications précédentes, **caractérisé en ce que** le signal (S8) de stimulation comprend au moins un signal (S8) de commande de stimulation sensorielle et/ou au moins un signal (S8) de commande d'injection d'un produit de contraste.

10. Module (6) de production d'un signal (S0) de référence IRM et/ou SRM suivant l'une quelconque des revendications précédentes, **caractérisé en ce que** le moyen de génération comporte un élément (620) de déclenchement du signal prescrit (RV) d'objet virtuel ou d'un signal obtenu à partir au moins du signal prescrit (RV) d'objet virtuel une pluralité de fois successives selon un séquencement déterminé en fonction du signal (S3) de synchronisation IRM et/ou SRM.

11. Module (6) de production d'un signal (S0) de référence IRM et/ou SRM suivant la revendication 10, **caractérisé en ce que** le séquencement déterminé est un séquencement du type EPI pour le signal (S3) de synchronisation IRM, l'objet virtuel d'IRM et le signal (S0) de référence IRM.

12. Module (6) de production d'un signal (S0) de référence IRM et/ou SRM suivant la revendication 10, **caractérisé en ce que** le séquencement déterminé est un retard du signal prescrit (RV) d'objet virtuel basé sur un temps d'écho (TE) extrait du signal (S3) de synchronisation IRM, pour l'objet virtuel (RVV) d'IRM et pour le signal (S0) de référence IRM.

13. Module (6) de production d'un signal (S0) de référence IRM et/ou SRM suivant l'une quelconque des revendications 1 à 12, **caractérisé en ce que** l'objet virtuel (RVV) d'IRM est une représentation visuelle du signal de référence (S0) d'IRM dans une image d'IRM.

14. Module (6) de production d'un signal (S0) de référence IRM et/ou SRM suivant l'une quelconque des revendications 1 à 10, **caractérisé en ce que** l'objet virtuel (RVV) de SRM est un premier spectre virtuel de SRM.

15. Procédé de production d'un signal (S0) de référence IRM et/ou SRM, à l'aide du module (6) de production suivant l'une quelconque des revendications précédentes, le procédé étant tel que :
- l'on envoie (E2) par un module (9) de commande de stimulation à la deuxième entrée (612) de réception, faisant partie du module (6) de production, un signal temporel (S8) de stimulation extérieur,
- l'on envoie (E3), par un ensemble (2) de mesure d'IRM et/ou de SRM, à la première entrée (621) de réception, faisant partie du module (6) de production, un signal (S3) de synchronisation IRM et/ou SRM,
- le moyen (62) de fourniture, faisant partie du module (6) de production, fournit (E3) un signal (RV) prescrit représentant un objet virtuel d'IRM et/ou de SRM,
- le moyen de génération, faisant partie du module (6) de production, utilise le signal (S3) de synchronisation IRM et/ou SRM, le signal temporel (S8) de stimulation extérieur et le signal (RV) prescrit d'objet virtuel d'IRM et/ou de SRM, pour générer (E4) le signal (S0) de référence IRM et/ou SRM, de telle sorte que le signal (S0) de référence IRM et/ou SRM varie temporellement de la même manière qu'une caractéristique temporelle déterminée du signal temporel (S8) de stimulation extérieur et en synchronisation avec le signal (S3) de synchronisation IRM et/ou SRM,
- la sortie (632) de fourniture, faisant partie du module (6) de production, fournit (E4) le signal (S0) de référence IRM et/ou SRM.

16. Programme d'ordinateur, comportant des instructions pour la mise en œuvre du procédé de production d'un signal (S0) de référence IRM et/ou SRM suivant la revendication 15, lorsqu'il est mis en œuvre sur un calculateur contrôlant un module (6) de production suivant l'une quelconque des revendications 1 à 14.

17. Dispositif d'imagerie IRM et/ou SRM, comportant :
- un ensemble (2) de mesure d'IRM et/ou de SRM, servant à l'émission de signaux (B0, S20, Gr) d'excitation IRM et/ou SRM dans un volume (100) d'examen dans lequel se trouve un corps (C) à étudier et à la détection de signaux (REP) de réponse IRM et/ou SRM émis par le corps (C) en réponse à ces signaux (B0, S20, Gr) d'excitation,
**caractérisé en ce que** le dispositif comporte en outre :
- le module (6) de production d'un signal (S0) de référence IRM et/ou SRM suivant l'une quelconque des revendications 1 à 14, dont la première entrée (621) de réception est connectée à une sortie (10) de fourniture du signal (S3) de synchronisation IRM et/ou SRM de l'ensemble (2) de mesure, et dont la deuxième entrée (612) de réception est connectée à un module (9) de commande de stimulation fournissant le signal (S8) temporel de stimulation extérieur,
- au moins une antenne (5) d'émission, qui est distincte de l'ensemble (2) de mesure et qui est connectée au module (6) de production pour émettre le signal (S0) de référence IRM et/ou SRM, de telle sorte que le signal (S0) de référence IRM et/ou SRM ayant été émis par l'antenne (5) d'émission soit détectable par l'ensemble (2) de mesure,
- un module (3) de commande, connecté à l'ensemble (2) de mesure et configuré pour générer, par traitement IRM et/ou SRM des signaux de réponse ayant été détectés par l'ensemble (2) de mesure et du signal (S0) de référence IRM et/ou SRM émis, ayant été détecté par l'ensemble (2) de mesure, au moins une image comportant :
• une représentation visuelle (RC) correspondant au corps (C) à étudier ou à une partie de celui-ci,
• l'objet virtuel (RVV) d'IRM et/ou de SRM représenté par le signal prescrit (RV) d'objet virtuel, cet objet virtuel (RVV) étant distinct de la représentation visuelle du corps (C) ou de la partie du corps,
- le module (9) de commande de stimulation étant connecté à un module (71) de stimulation sensorielle du corps (C) étant un être vivant pour la fourniture à ce dernier du signal (S8) temporel de stimulation extérieur, le module (71) de stimulation sensorielle étant apte à émettre au moins une stimulation sensorielle (S1), autre que les signaux (B0, S20, Gr) d'excitation IRM et/ou SRM, à destination du corps (C) en fonction du signal (S8) temporel de stimulation extérieur.

18. Procédé d'imagerie IRM et/ou SRM, dans lequel
- on émet (E1) par un ensemble (2) de mesure d'IRM et/ou de SRM, des signaux (B0, S20, Gr) d'excitation IRM et/ou SRM dans un volume (100) d'examen dans lequel se trouve un corps (C) à étudier,
**caractérisé en ce que**
- l'on envoie (E2), par un module (9) de commande de stimulation, un signal (S8) temporel de stimulation extérieur à une deuxième entrée (612) de réception du module (6) de production suivant l'une quelconque des revendications 1 à 14 et à un module (71) de stimulation sensorielle, lequel, émet (E2) au moins une stimulation sensorielle (S1), autre que les signaux (B0, S20, Gr) d'excitation IRM et/ou SRM, à destination du corps (C) en fonction du signal (S8) temporel de stimulation extérieur,
- l'on envoie (E3), par l'ensemble (2) de mesure d'IRM et/ou de SRM, à une première entrée (621) de réception du module (6) de production, un signal (S3) de synchronisation IRM et/ou SRM,
- on produit (E4) un signal (S0) de référence IRM et/ou SRM par le module (6) de production en fonction du signal (S8) temporel de stimulation extérieur, en fonction du signal (S3) de synchronisation IRM et/ou SRM et en fonction du signal prescrit (RV) d'objet virtuel présent dans le module (6) de production,
- on émet (E4) par au moins une antenne (5) d'émission, qui est distincte de l'ensemble (2) de mesure et qui est connectée au module (6) de production, le signal (S0) de référence IRM et/ou SRM,
- on détecte (E5), par l'ensemble (2) de mesure, des signaux (REP) de réponse IRM et/ou SRM émis par le corps (C) en réponse aux signaux (B0, S20, Gr) d'excitation et on détecte (E5) par l'ensemble (2) de mesure le signal (S0) de référence IRM et/ou SRM ayant été émis par l'antenne (5) d'émission,
- on génère (E6) par un module (3) de commande, connecté à l'ensemble (2) de mesure, par traitement IRM et/ou SRM des signaux (REP) de réponse ayant été détectés par l'ensemble (2) de mesure et du signal (S0) de référence IRM et/ou SRM émis, ayant été détecté par l'ensemble (2) de mesure, au moins une image (I, SP) comportant :
• une représentation visuelle (RC) correspondant au corps (C) à étudier ou à une partie de celui-ci,
• l'objet virtuel (RVV) d'IRM et/ou de SRM représenté par le signal prescrit (RV) d'objet virtuel, cet objet virtuel (RVV) étant distinct de la représentation visuelle (RC) du corps (C) ou de la partie du corps.

19. Programme d'ordinateur, comportant des instructions pour la mise en œuvre du procédé d'imagerie IRM et/ou SRM suivant la revendication 18, lorsqu'il est mis en œuvre sur un calculateur contrôlant un module (6) de production suivant la revendication 17.

## Patentansprüche

1. Modul (6) zur Erzeugung eines MRT- und/oder MRS-Referenzsignals (S0), wobei das Modul umfasst:
- einen ersten Eingang (621) zum Empfang eines MRT- und/oder MRS-Synchronisationssignals (S3),
- ein Mittel (62) zur Bereitstellung eines vorgeschriebenen Signals (RV), das ein virtuelles MRT- und/oder MRS-Objekt (RVV) darstellt,
- ein Mittel zur Generierung des MRT- und/oder MRS-Referenzsignals (S0) durch Verwendung des MRT- und/oder MRS-Synchronisationssignals (S3) mit dem vorgeschriebenen Signal (RV) eines virtuellen MRT- und/oder MRS-Objekts,
- einen Ausgang (632) zur Bereitstellung des MRT- und/oder MRS-Referenzsignals (S0),
**dadurch gekennzeichnet, dass**
das Modul einen zweiten Eingang (612) zum Empfang eines externen zeitlichen Stimulationssignals (S8) aufweist,
das Mittel zur Generierung des MRT- und/oder MRS-Referenzsignals (S0) so konfiguriert ist, dass das externe zeitliche Stimulationssignal (S8) verwendet wird, um das MRT- und/oder MRS-Referenzsignal (S0) genauso wie eine bestimmte zeitliche Charakteristik des externen zeitlichen Stimulationssignals (S8) und synchron mit dem MRT- und/oder MRS-Synchronisationssignal (S3) zeitlich zu variieren.

2. Modul (6) zur Erzeugung eines MRT- und/oder MRS-Referenzsignals (S0) nach Anspruch 1, **dadurch gekennzeichnet, dass** das Mittel (62) zur Bereitstellung eines vorgeschriebenen Signals (RV), das ein virtuelles MRT- und/oder MRS-Objekt (RVV) darstellt, einen Speicher (626) umfasst, in dem als vorgeschriebenes Signal (RV), das ein virtuelles MRT- und/oder MRS-Objekt darstellt, eine Fourier-Transformation im k-Raum des virtuellen Objekts (RVV) oder eine Darstellung im reziproken k-Raum des virtuellen Objekts (RVV) gespeichert ist.

3. Modul (6) zur Erzeugung eines MRT- und/oder MRS-Referenzsignals (S0) nach Anspruch 2, **dadurch gekennzeichnet, dass** im Speicher eine Vielzahl von Fouriertransformationen von jeweils einer Vielzahl von einzelnen virtuellen Objekten (RVV) im k-Raum oder eine Vielzahl von Darstellungen im reziproken k-Raum einer Vielzahl von einzelnen virtuellen Objekten (RVV) gespeichert ist,
wobei die Fouriertransformationen oder die Darstellungen im reziproken k-Raum einer Vielzahl von einzelnen virtuellen Objekten (RVV) mit voneinander verschiedenen Amplituden und/oder voneinander verschiedenen Formen und/oder voneinander verschiedenen Positionen aufweisen.

4. Modul (6) zur Erzeugung eines MRT- und/oder MRS-Referenzsignals (S0) nach einem beliebiegen der vorstehenden Ansprüche, **dadurch gekennzeichnet, dass** das Generierungsmittel ein Element (61) zur Multiplikation des vorgeschriebenen Signals (RV) eines virtuellen Objekts oder eines aus mindestens dem vorgeschriebenen Signal (RV) eines virtuellen Objekts erhaltenen Signals mit dem externen zeitlichen Stimulationssignal (S8) aufweist.

5. Modul (6) zur Erzeugung eines MRT- und/oder MRS-Referenzsignals (S0) nach einem beliebiegen der vorstehenden Ansprüche, **dadurch gekennzeichnet, dass** das Generierungsmittel ein Element (63) zur Frequenztransposition des vorgeschriebenen Signals (RV) eines virtuellen Objekts oder eines aus mindestens dem vorgeschriebenen Signal (RV) eines virtuellen Objekts erhaltenen Signals bei einer oder mehreren bestimmten MRT- und/oder MRS-Frequenzen aufweist.

6. Modul (6) zur Erzeugung eines MRT- und/oder MRS-Referenzsignals (S0) nach dem vorstehenden Anspruch, **dadurch gekennzeichnet, dass** die ermittelte Frequenz der MRT- und/oder MRS-Larmorfrequenz ist.

7. Modul (6) zur Erzeugung eines MRT- und/oder MRS-Referenzsignals (S0) nach einem beliebiegen der vorstehenden Ansprüche, **dadurch gekennzeichnet, dass** der Ausgang (632) mit einer Antenne (5) zur Aussendung des MRT- und/oder MRS-Referenzsignals (S0) verbunden ist.

8. Modul (6) zur Erzeugung eines MRT- und/oder MRS-Referenzsignals (S0) nach einem beliebiegen der vorstehenden Ansprüche, **dadurch gekennzeichnet, dass** das Stimulationssignal (S8) ein Signal (S8) zur Steuerung der Stimulation eines Lebewesens (C) ist.

9. Modul (6) zur Erzeugung eines MRT- und/oder MRS-Referenzsignals (S0) nach einem beliebiegen der vorstehenden Ansprüche, **dadurch gekennzeichnet, dass** das Stimulationssignal (S8) mindestens ein Signal (S8) zur Steuerung der sensorischen Stimulation und/oder mindestens ein Signal (S8) zur Steuerung der Einspritzung eines Kontrastmittels umfasst.

10. Modul (6) zur Erzeugung eines MRT- und/oder MRS-Referenzsignals (S0) nach einem beliebiegen der vorstehenden Ansprüche, **dadurch gekennzeichnet, dass** das Generierungsmittel ein Element (620) zum Auslösen des vorgeschriebenen Signals (RV) oder eines aus mindestens dem vorgeschriebenen Signal (RV) eines virtuellen Objekts erhaltenen Signals mehrmals hintereinander gemäß einer Sequenzierung aufweist, die je nach MRT- und/oder MRS-Synchronisationssignal (S3) bestimmt wird.

11. Modul (6) zur Erzeugung eines MRT- und/oder MRS-Referenzsignals (S0) nach Anspruch 10, **dadurch gekennzeichnet, dass** die bestimmte Sequenzierung eine Sequenzierung des Typs EPI für das MRT-Synchronisationssignal (S3), das virtuelle MRT-Objekt und das MRT-Referenzsignal (S0) ist.

12. Modul (6) zur Erzeugung eines MRT- und/oder MRS-Referenzsignals (S0) nach Anspruch 10, **dadurch gekennzeichnet, dass** die bestimmte Sequenzierung eine Verzögerung des vorgeschriebenen Signals (RV), die auf einer aus dem MRT-Synchronisationssignal (S3) extrahierten Echozeit basiert ist, für das virtuelle MRT-Objekt (RVV) und das MRT-Referenzsignal (S0).

13. Modul (6) zur Erzeugung eines MRT- und/oder MRS-Referenzsignals (S0) nach einem beliebiegen der Ansprüche 1 bis 12, **dadurch gekennzeichnet, dass** das virtuelle MRT-Objekt (RVV) eine visuelle Darstellung des MRT-Referenzsignals (S0) in einem MRT-Bild ist.

14. Modul (6) zur Erzeugung eines MRT- und/oder MRS-Referenzsignals (S0) nach einem beliebiegen der Ansprüche 1 bis 10, **dadurch gekennzeichnet, dass** das virtuelle MRS-Objekt (RVV) ein erstes virtuelles MRS-Spektrum ist.

15. Verfahren zur Erzeugung eines MRT- und/oder MRS-Referenzsignals (S0) mittels eines Erzeugungsmoduls (6) nach einem beliebiegen der vorstehenden Ansprüche, wobei das Verfahren derart ist, dass:
- ein externes zeitliches Stimulationssignal (S8) durch ein Modul (9) zur Stimulationssteuerung an den zweiten Empfangseingang (612), der zum Erzeugungsmodul (6) gehört, gesendet (E2) wird,
- ein MRT- und/oder MRS-Synchronisationssignal (S3) durch eine MRT- und/oder MRS-Messanordnung (2) an den ersten Empfangseingang (621), der zum Erzeugungsmodul (6) gehört, gesendet (E3) wird,
- das Bereitstellungsmittel (62), das zum Erzeugungsmodul (6) gehört, ein vorgeschriebenes Signal (RV) bereitstellt (E3), das ein virtuelles MRT- und/oder MRS-Objekt darstellt,
- das Generierungsmittel, das zum Erzeugungsmodul (6) gehört, verwendet das MRT- und/oder MRS-Synchronisationssignal (S3), das externe zeitliche Stimulationssignal (S8) und das vorgeschriebene Signal (RV) eines virtuellen MRT- und/oder MRS-Objekts, um das MRT- und/oder MRS-Referenzsignal (S0) zu generieren (E4), sodass das MRT- und/oder MRS-Referenzsignal (S0) genauso wie eine bestimmte zeitliche Charakteristik des externen zeitlichen Stimulationssignals (S8) und synchron mit dem MRT- und/oder MRS-Synchronisationssignal (S3) zeitlich variiert,
- der Bereitstellungsausgang (632), der zum Erzeugungsmodul (6) gehört, das MRT- und/oder MRS-Referenzsignal (S0) bereitstellt (E4).

16. Computerprogramm, das Anweisungen zur Umsetzung des Verfahrens zur Erzeugung eines MRT- und/oder MRS-Referenzsignals (S0) nach Anspruch 15 aufweist, wenn es auf einem Rechner, der ein Erzeugungsmodul (6) nach einem der Ansprüche 1 bis 14 steuert, ausgeführt wird.

17. MRT- und/oder MRS-Bildgebungsvorrichtung mit:
- einer MRT- und/oder MRS-Messanordnung (2) zur Aussendung von MRT- und/oder MRS-Erregungssignalen (B0, S20, Gr) in ein Untersuchungsvolumen (100), in dem sich ein zu untersuchender Körper (C) befindet, und zur Detektion von MRT- und/oder MRS-Antwortsignalen (REP), die vom Körper (C) als Antwort auf diese Erregungssignale (B0, S20, Gr) ausgesendet werden,
**dadurch gekennzeichnet, dass** die Vorrichtung zudem umfasst:
- das Modul (6) zur Erzeugung eines MRT- und/oder MRS-Referenzsignals (S0) nach einem beliebiegen der Ansprüche 1 bis 14, dessen erste Empfangseingang (621) mit einem Ausgang (10) zur Bereitstellung des MRT- und/oder MRS-Synchronisationssignals (S3) der Messanordnung (2) verbunden ist und dessen zweite Empfangseingang (612) mit einem Modul (9) zur Stimulationssteuerung verbunden ist, das das externe zeitliche Stimulationssignal (S8) bereitstellt,
- mindestens eine Übertragungsantenne (5), die von der Messanordnung (2) verschieden ist und die mit dem Erzeugungsmodul (6) verbunden ist, um das MRT- und/oder MRS-Referenzsignal (S0) zu übertragen, sodass das MRT- und/oder MRS-Referenzsignal (S0), das durch die Aussendungssantenne (5) ausgesendet wurde, durch die Messanordnung (2) detektiert werden kann,
- ein Steuermodul (3), das mit der Messanordnung (2) verbunden ist und so konfiguriert ist, dass mittels MRT- und/oder MRS-Verarbeitung der Antwortsignale, die von der Messanordnung (2) detektiert wurden, und des ausgesendeten MRT- und/oder MRS-Referenzsignals (S0), das von der Messanordnung (2) detektiert wurde, mindestens ein Bild generiert wird, das Folgendes umfasst:
• eine visuelle Darstellung (RC), die dem zu untersuchenden Körper (C) oder einem Teil davon entspricht,
• das virtuelle MRT- und/oder MRS-Objekt (RVV), das durch das vorgeschriebene Signal (RV) eines virtuellen Objekts dargestellt wird, wobei dieses virtuelle Objekt (RVV) von der visuellen Darstellung des Körpers (C) oder eines Teils davon unterschieden ist,
- das Modul (9) zur Stimulationssteuerung, das mit einem Modul (71) zur sensoriellen Stimulation des Körpers (C), das ein Lebewesen ist, für die Bereitstellung des externen zeitlichen Stimulationssignals (S8) an diesen Körper verbunden ist, wobei das Modul (71) zur sensoriellen Stimulation in der Lage ist, mindestens eine sensorielle Stimulation (S1), die sich von den MRT- und/oder MRS-Erregungssignalen (B0, S20, GR) unterscheidet, an den Körper (C) in Abhängigkeit des externen zeitlichen Stimulationssignals (S8) auszusenden.

18. MRT- und/oder MRS-Bildgebungsverfahren, bei dem:
- MRT- und/oder MRS-Erregungssignalen (B0, S20, Gr) durch eine MRT- und/oder MRS-Messanordnung (2) in ein Untersuchungsvolumen (100), in dem sich ein zu untersuchender Körper (C) befindet, ausgesendet werden, **dadurch gekennzeichnet dass**
- ein externes zeitliches Stimulationssignal (S8) durch ein Modul (9) zur Stimulationssteuerung an einen zweiten Empfangseingang (612) des Erzeugungsmodul (6) nach einem beliebiegen der Ansprüche 1 bis 14 und und an ein Modul (71) zur sensoriellen Stimulation ausgesendet (E2) wird, das mindestens eine sensorielle Stimulation (S1), die sich von den MRT- und/oder MRS-Erregungssignalen (B0, S20, GR) unterscheidet, an den Körper (C) in Abhängigkeit des externen zeitlichen Stimulationssignals (S8), ausgesendet (E2) wird,
- ein MRT- und/oder MRS-Synchronisationssignal (S3) durch die MRT- und/oder MRS-Messanordnung (2) an einen ersten Empfangseingang (621) des Erzeugungsmoduls (6) gesendet (E3) wird,
- ein MRT- und/oder MRS-Referenzsignal (S0) durch das Erzeugungsmodul (6) in Abhängigkeit des externen zeitlichen Stimulationssignals (S8), in Abhängigkeit des MRT- und/oder MRS-Synchronisationssignals (S3) und in Abhängigkeit des vorgeschriebenen Signals (RV) eines virtuellen Objekts, das im Erzeugungsmodul (6) vorhanden ist, erzeugt wird (E4),
- das MRT- und/oder MRS-Referenzsignals (S0) durch mindestens eine Aussendungsantenne (5), die von der Messanordnung (2) verschieden ist und die mit dem Erzeugungsmodul (6) verbunden ist, ausgesendet (E4) wird,
- MRT- und/oder MRS-Antwortsignale (REP), die vom Körper (C) als Antwort auf die Erregungssignale (B0, S20, Gr) ausgesendet werden detektiert werden (E5), und das MRT- und/oder MRS-Referenzsignal (S0), das von der Aussendungsantenne (5) ausgesendet wurde, durch die Messanordnung (2) detektiert wird (E5),
- mindestens ein Bild (I, SP) durch ein Steuermodul (3), das mit der Messanordnung (2) verbunden ist, mittels MRT- und/oder MRS-Verarbeitung der Antwortsignale (REP), die von der Messanordnung (2) detektiert wurden, und des ausgesendeten MRT- und/oder MRS-Referenzsignals (S0), das von der Messanordnung (2) detektiert wurde, generiert (E6) wird, wobei das mindestens eine Bild (I, SP) Folgendes umfasst:
• eine visuelle Darstellung (RC), die dem zu untersuchenden Körper (C) oder einem Teil davon entspricht,
• das virtuelle MRT- und/oder MRS-Objekt (RVV), das durch das vorgeschriebene Signal (RV) eines virtuellen Objekts dargestellt wird, wobei dieses virtuelle Objekt (RVV) von der visuellen Darstellung des Körpers (C) oder eines Teils davon unterschieden ist.

19. Computerprogramm, das Anweisungen zur Umsetzung des MRT- und/oder MRS-Bildgebungsverfahrens nach Anspruch 18 aufweist, wenn es auf einem Rechner, der ein Erzeugungsmodul (6) nach Anspruch 17 steuert, ausgeführt wird.

## Claims

1. A module (6) for producing an MRI and/or MRS reference signal (S0), **characterized in that** the module comprises:
- a first receiving input (621) for receiving of an MRI and/or MRS synchronization signal (S3),
- supply means (62) for supplying of a prescribed signal (RV) representing an MRI and/or MRS virtual object (RVV),
- generating means for generating of the MRI and/or MRS reference signal (S0) by use of the MRI and/or MRS synchronization signal (S3) with the MRI and/or MRS virtual object prescribed signal (RV),
- a supply output (632) for supplying of the MRI and/or MRS reference signal (S0),
**characterized in that**
the module comprises a second receiving input (612) for receiving of a time signal (S8) of external stimulation,
the generating means for generating of the MRI and/or MRS reference signal (S0) is configured to use the time signal (S8) of external stimulation for temporally varying the MRI and/or MRS reference signal (S0) in the same way as a determined time characteristic of the time signal (S8) of external stimulation and in synchronization with the MRI and/or MRS synchronization signal (S3).

2. The module (6) for producing an MRI and/or MRS reference signal (S0) according to claim 1, **characterized in that** the supply means (62) for supplying of a prescribed signal (RV) representing an MRI and/or MRS virtual object (RVV) comprises a memory (626) in which is recorded as prescribed signal (RV) representing an MRI and/or MRS virtual object (RVV) a Fourier transform, in the k-space, of the virtual object (RVV) or a representation in the reciprocal k-space of the virtual object (RW).

3. The module (6) for producing an MRI and/or MRS reference signal (S0) according to claim 2, **characterized in that** in the memory is recorded a multiplicity of Fourier transforms of respectively a multiplicity of distinct virtual objects (RVV) in the k-space or a multiplicity of representations in the reciprocal k-space of a multiplicity of distinct virtual objects (RVV),
wherein the Fourier transforms or the representations in the reciprocal k-space of a multiplicity of distinct virtual objects (RVV) have amplitudes distinct from each other and/or shapes distinct from each other and/or positions distinct from each other.

4. The module (6) for producing an MRI and/or MRS reference signal (S0) according to any one of the preceding claims, **characterized in that** the generating means comprises a multiplication element (61) for multiplying of the virtual object prescribed signal (RV) or of a signal obtained from at least the virtual object prescribed signal (RV) by the time signal (S8) of external stimulation.

5. The module (6) for producing an MRI and/or MRS reference signal (S0) according to any one of the preceding claims, **characterized in that** the generating means comprises an element (63) of frequential transposition of the virtual object prescribed signal (RV) or of a signal obtained from at least the virtual object prescribed signal (RV) to one or more MRI and/or MRS determined frequencies.

6. The module (6) for producing an MRI and/or MRS reference signal (S0) according to the preceding claim, **characterized in that** the determined frequency is the MRI and/or MRS Larmor frequency.

7. The module (6) for producing an MRI and/or MRS reference signal (S0) according to any one of the preceding claims, **characterized in that** the output (632) is connected to an antenna (5) for emitting of the MRI and/or MRS reference signal (S0).

8. The module (6) for producing an MRI and/or MRS reference signal (S0) according to any one of the preceding claims, **characterized in that** the time signal (S8) of external stimulation is a signal (S9) of control of stimulation of a living being (C).

9. The module (6) for producing an MRI and/or MRS reference signal (S0) according to any one of the preceding claims, **characterized in that** the time signal (S8) of external stimulation comprises at least one signal (S8) of control of sensory stimulation and/or at least one signal (S8) of control of injection of a contrast product.

10. The module (6) for producing an MRI and/or MRS reference signal (S0) according to any one of the preceding claims, **characterized in that** the generating means comprises an element (620) for triggering of the virtual object prescribed signal (RV) or of a signal obtained from at least the virtual object prescribed signal (RV) a plurality of successive times according to sequencing determined as a function of the MRI and/or MRS synchronization signal (S3).

11. The module (6) for producing an MRI and/or MRS reference signal (S0) according to claim 10, **characterized in that** the determined sequencing is sequencing of EPI type for the MRI synchronization signal (S3), the MRI virtual object and the MRI reference signal (S0).

12. The module (6) for producing an MRI and/or MRS reference signal (S0) according to claim 10, **characterized in that** the determined sequencing is a delay of the virtual object prescribed signal (RV) based on echo time (TE) extracted from the MRI synchronization signal (S3), for the MRI virtual object (RVV) and for the MRI reference signal (S0).

13. The module (6) for producing an MRI and/or MRS reference signal (S0) according to any one of claims 1 to 12, **characterized in that** the MRI virtual object (RVV) is a visual representation of the MRI reference signal (S0) in an MRI image.

14. The module (6) for producing an MRI and/or MRS reference signal (S0) according to any one of claims 1 to 10, **characterized in that** the MRS virtual object (RVV) is a first MRS virtual spectrum.

15. A method for producing an MRI and/or MRS reference signal (S0), by means of the production module (6) according to any one of the preceding claims, **characterized in that**
- a time signal (S8) of external stimulation is sent (E2) by a stimulation control module (9) to the second receiving input (612), forming part of the production module (6),
- an MRI and/or MRS synchronization signal (S3) is sent (E3) by an MRI and/or MRS measuring assembly (2) to the first receiving input (621) forming part of the production module (6),
- the supply means (62), forming part of the production module (6), provides (E3) a prescribed signal (RV) representing an MRI and/or MRS virtual object,
- the generating means, forming part of the production module (6), uses the MRI and/or MRS synchronization signal (S3), the time signal (S8) of external stimulation and the MRI and/or MRS virtual object prescribed signal (RV), to generate (E4) the MRI and/or MRS reference signal (S0), such that the MRI and/or MRS reference signal (S0) varies temporally in the same way as a time determined characteristic of the time signal (S8) of external stimulation and in synchronization with the MRI and/or MRS synchronization signal (S3),
- the supply output (632), forming part of the production module (6), provides (E4) the MRI and/or MRS reference signal (S0).

16. A computer program, comprising instructions for executing the method for producing an MRI and/or MRS reference signal (S0), according to claim 15, when it is run on a calculator controling a production module (6) according to any one of claims 1 to 14.

17. An MRI and/or MRS imaging device, comprising:
- an MRI and/or MRS measuring assembly (2), for emitting MRI and/or MRS excitation signals (B0, S20, Gr) in an examination volume (100) containing a body (C) to be studied and for detecting MRI and/or MRS response signals (REP) emitted by the body (C) in response to these excitation signals (B0, S20, Gr), **characterized in that** the device further comprises:
- the module (6) for producing an MRI and/or MRS reference signal (S0) according to any one of claims 1 to 14, whereof the first receiving input (621) is connected to a supply output (10) for supplying of the MRI and/or MRS synchronization signal (S3) of the measuring assembly (2), and whereof the second receiving input (612) is connected to a stimulation control module (9) providing the time signal (S8) of external stimulation,
- at least one emitting antenna (5), which is distinct from the measuring assembly (2) and which is connected to the production module (6) for emitting the MRI and/or MRS reference signal (S0), such that the MRI and/or MRS reference signal (S0) having been emitted by the emitting antenna (5) can be detected by the measuring assembly (2),
- a control module (3), connected to the measuring assembly (2) and configured for generating, by MRI and/or MRS processing of the response signals having been detected by the measuring assembly (2) and of the emitted MRI and/or MRS reference signal (S0), having been detected by the measuring assembly (2), at least one image comprising:
• a visual representation (RC) corresponding to the body (C) to be studied or to a part of the latter,
• the MRI and/or MRS virtual object (RVV) represented by the virtual object prescribed signal (RV), this virtual object (RVV) being distinct from the visual representation of the body (C) or of the part of the body,
- the stimulation control module (9) being connected to a module (71) for sensory stimulation of the body (C) being a living being for providing the latter with the time signal (S8) of external stimulation, the module (71) for sensory stimulation being capable of emitting at least one sensory stimulation (S1), other than the MRI and/or MRS excitation signals (B0, S20, Gr), to the body (C) as a function of the time signal (S8) of external stimulation.

18. An MRI and/or MRS imaging method, wherein
- MRI and/or MRS excitation signals (B0, S20, Gr) are emitted (E1) by an MRI and/or MRS measuring assembly (2) in an examination volume (100) containing a body (C) to be studied
**characterized in that**
- a time signal (S8) of external stimulation is sent (E2) by a stimulation control module (9) to a second receiving input (612) of the production module (6), according to any one of claims 1 to 14 and to a sensory stimulation module (71), which emits (E2) at least one sensory stimulation (S1), other than the MRI and/or MRS excitation signals (B0, S20, Gr), to the body (C) as a function of the time signal (S8) of external stimulation,
- an MRI and/or MRS synchronization signal (S3) is sent (E3) by the MRI and/or MRS measuring assembly (2) to a first receiving input (621) of the production module (6),
- an MRI and/or MRS reference signal (S0) is produced (E4) by the production module (6) as a function of the time signal (S8) of external stimulation, as a function of the MRI and/or MRS synchronization signal (S3) and as a function of the virtual object prescribed signal (RV) present in the production module (6),
- the MRI and/or MRS reference signal (S0) is emitted (E4) by at least one emitting antenna (5), which is distinct from the measuring assembly (2) and which is connected to the production module (6),
- MRI and/or MRS response signals (REP) emitted by the body (C) in response to the excitation signals (B0, S20, Gr) are detected (E5) by the measuring assembly (2), and the MRI and/or MRS reference signal (S0) having been emitted by the emitting antenna (5) is detected (E5) by the measuring assembly (2),
- at least one image (I, SP) is generated (E6) by a control module (3), connected to the measuring assembly (2), by MRI and/or MRS processing of the response signals (REP) having been detected by the measuring assembly (2) and of the emitted MRI and/or MRS reference signal (S0), having been detected by the measuring assembly (2), the at least one image (I, SP) comprising:
• a visual representation (RC) corresponding to the body (C) to be studied or to a part of the latter,
• the MRI and/or MRS virtual object (RVV) represented by the virtual object prescribed signal (RV), this virtual object (RVV) being distinct from the visual representation (RC) of the body (C) or of the part of the body.

19. A computer program, comprising instructions for executing the MRI and/or MRS imaging method according to claim 18, when it is run on a calculator controling a production module (6) according to claim 17.
